# EUROPEAN PATENT APPLICATION

(11) **EP 4 614 424 A1**
(43) Date of publication of application: **10.09.2025**
(21) Application number: 25161294.1
(22) Date of filing: 03.03.2025
(51) Int. Cl.: G06Q 50/06, G01D 4/00, G01R 19/25, G05B 15/02

(54) **SIGNAL EXTRACTION AND ALARMING FOR ENERGY MANAGEMENT**

(30) Priority: 06.03.2024 US 202418597255
(71) Applicant: Schneider Electric USA, Inc., Boston, MA 02108 (US)
(72) Inventor: Menzel, Johannes, 38320 Eybens (FR); Gaffet, Clément, 38360 Sassenage (FR)
(74) Representative: Friese Goeden Patentanwälte PartGmbB

(57) **Abstract**

Signal extraction enables advanced energy analytics. Energy consumption data collected for a site by energy consumption meters is disaggregated into a plurality of granular classifications by identifying baseload candidates among the data, grouping sequences of the baseload candidates based on timestamps, and categorizing the grouped sequences as either baseload points or non-baseload points, including transition and open hours classifications. A per meter model of normal energy consumption from the energy consumption data is generated as a function of the baseload points and timestamps and the data is analyzed to identify incoherences relative to the model.

## Description

### FIELD

Aspects and embodiments of the present disclosure are directed generally to the evaluation of energy management within any building or process, such as any commercial, industrial or institutional facility.

### BACKGROUND

Energy management is an important driver in financial performance and corporate value. Buildings are a major contributor of global energy consumption. For example, buildings often account for 40% or more of a country's total energy consumed yet only a small percentage (e.g., 5-10%) of buildings are equipped with an energy management system (or similar analysis or control system for monitoring and managing energy usage). Current energy consumption analysis often focuses either on monthly values or now increasingly on daily values such as measured consumption values for a day, such as a sum, a maximum value, a minimum value, a mean value, or a median value. The minimum value is sometimes wrongly called a baseload. This minimum value may sometimes be close to the baseload level, but the minimum value never catches the variance of the baseload period. The maximum value impacts the yearly costs of energy usage as it may define the contract with the energy provider(s). The sum or mean (and less frequently the median) are used for calculations, such as in reports that aggregate usage of meters or main meters per day.

The minimum and maximum energy consumption values for a day provide information about extreme values, rather than the intervals of different levels of energy consumption throughout a given day or time period. For example, the minimum value is helpful to determine the variance of baseload period as well as to detect outlier values, e.g., specific times when the energy is lowest per day or on a given time period. Similarly, the sum, mean and median values are aggregated statistical values, and as such do not contain detailed information about intervals of different levels of energy consumption throughout a given day or time period.

Commonly assigned U.S. Patent No. 10,120,353 and U.S. Patent No. 10,921,762 disclose methods and systems of energy management that collect energy consumption data over time, identify clusters within the data, and assign energy consumption classifications to the period of time based on the clusters of data (e.g., based on a statistical classification of energy values collected over several days or weeks or months or any relevant time period).

### SUMMARY

Aspects of the present disclosure permit assessment of facilities to determine metering and monitoring requirements, whether remote or on-site, and installation of an energy metering system having meters connected to an on-premise and/or cloud-based energy management system to monitor load consumption by building, floor, zone, room, load types, equipment, process, etc. An energy management system embodying aspects of the present disclosure monitors real-time energy consumption, identifies inefficiencies, supports decision-making and controlling loads and prioritizes measures, analyzes savings, and manages alarms and load shedding to lower peak demand thus closing the efficiency gap to reduce energy consumption, peak demand, and costs. In an aspect, energy meters, monitoring systems, and the like assess energy usage at a site. Monitoring real-time energy consumption permits identifying inefficiencies, supporting decision-making and controlling loads, and prioritizing energy-saving measures. Analytics can be leveraged with real-time dashboards, reports, alarms, and predictive energy consumption. Software executing energy management in accordance with embodiments of the present disclosure may be embedded into power meters, gateways, edge computing devices and software, cloud computing, and other devices/software or another head-end system, and provides more robust feature extraction and greater details/discrimination of features in the classification of energy consumption to detect potential savings in both unmanaged and managed sites.

In an aspect, a method for providing signal extraction and alarming to enable advanced energy analytics includes collecting energy consumption data for a site using one or more energy consumption meters. The energy consumption data comprises a plurality of data points each having a timestamp and a value representative of a level of energy usage. The method further comprises disaggregating the data points into a plurality of granular classifications, including identifying baseload candidates among the data points as a function of the data point values relative to an upper threshold and a lower threshold, grouping sequences of the baseload candidates based on the data point timestamps, and categorizing the data points of the grouped sequences of baseload candidates as either baseload points or non-baseload points. The method also includes generating a per meter model of normal energy consumption from the energy consumption data as a function of the baseload points and the data point timestamps, analyzing the energy consumption data to identify one or more incoherences therein relative to the model, and performing at least one action responsive to the identified incoherences and then triggering the at least one action.

In another aspect, a system for energy management comprises one or more energy consumption meters configured to collect energy consumption data for a site. The energy consumption data includes a plurality of data points each having a timestamp and a value representative of a level of energy usage. The system further comprises a controller in communication with the one or more energy consumption meters. The controller has a processor and a memory component. The memory component stores processor-executable instructions that, when executed, configure the processor to identify baseload candidates among the data points as a function of the data point values relative to an upper threshold and a lower threshold, group sequences of the baseload candidates based on the data point timestamps, and categorize the data points of the grouped sequences of baseload candidates as either baseload points or non-baseload points. The memory component stores processor-executable instructions that, when executed, further configure the processor to generate a per meter model of normal energy consumption from the energy consumption data as a function of the baseload points and the data point timestamps, analyze the energy consumption data to identify one or more incoherences therein relative to the model, and perform at least one action responsive to the identified incoherences and then trigger the at least one action.

In another aspect, a method of providing energy analytics comprises collecting energy consumption data for a site having a plurality of loads using one or more energy consumption meters. The energy consumption meters are each associated with one or more of the loads and the energy consumption data collected from each of the energy consumption meters comprises a plurality of data points each having a timestamp and a value representative of a level of energy usage by the one or more of the loads associated therewith. The method also includes disaggregating the data points into a plurality of granular classifications as a function of the data point values and the data point timestamps, analyzing the energy consumption data in view of the classifications and in view of additional site information and historical energy consumption data to identify one or more periods of over consumption and associated over consumption patterns for the site, and analyzing the periods of over consumption and associated over consumption patterns. The method further comprises providing information of the periods of over consumption and associated over consumption patterns in at least one visualization, which includes a recommendation for improving energy consumption efficiency for the site.

In yet another aspect, a system for energy management comprises one or more energy consumption meters configured to collect energy consumption data for a site. The energy consumption meters are each associated with one or more of the loads and the energy consumption data collected from each of the energy consumption meters comprises a plurality of data points each having a timestamp and a value representative of a level of energy usage by the one or more of the loads associated therewith. The system further comprises a controller in communication with the one or more energy consumption meters. The controller has a processor and a memory component and the memory component stores processor-executable instructions that, when executed, configure the processor to disaggregate the data points into a plurality of granular classifications as a function of the data point values and the data point timestamps. The memory component stores processor-executable instructions that, when executed, further configure the processor to analyze the energy consumption data in view of the classifications and in view of additional site information and historical energy consumption data, analyze the periods of over consumption and associated over consumption patterns to identify which of the one or more loads is a main contributor and a root source of over consumption, and provide information of the periods of over consumption and associated over consumption patterns in at least one visualization, which includes a recommendation for improving energy consumption efficiency for the site.

Other objects and features of the present invention will be in part apparent and in part pointed out herein.

### BRIEF DESCRIPTION OF THE DRAWINGS

FIG. 1 is a schematic diagram of an energy management system according to an embodiment.
FIGS. 2A to 2F are simplified energy usage diagrams according to an embodiment.
FIG. 3 illustrates an example of an energy usage curve representing an extracted energy signal according to an embodiment.
FIG. 4 is a flow diagram illustrating an exemplary process for classifying data points of an extracted energy signal according to an embodiment.
FIG. 5 illustrates an example of an energy usage curve representing a smoothed extracted energy signal according to an embodiment.
FIGS. 6A to 6D are examples of energy usage curves illustrating aspects of classifying baseload data points according to an embodiment.
FIGS. 7-10 are examples of energy usage curves illustrating aspects of classifying transition data points according to an embodiment.
FIG. 11 is an example of an energy usage curve illustrating aspects of classifying outlier data points according to an embodiment.
FIG. 12A is an example of an energy usage curve illustrating energy usage on an open day according to an embodiment.
FIG. 12B illustrates multiple example energy usage curves for identifying patterns among open days according to an embodiment.
FIG. 13 is an example of an energy usage curve illustrating abnormally high energy usage on a closed day according to an embodiment.
FIG. 14 is an example of an energy usage curve illustrating an elevated baseload level on a closed day according to an embodiment.
FIG. 15A and FIG. 15B are a flow diagram illustrating an exemplary process for advanced analytics of potential energy savings according to an embodiment.
FIG. 16 is an example of an energy usage curve illustrating per meter energy usage on an open day according to an embodiment.
FIGS. 17A to 17C are example heat map visualizations demonstrating impacts of over consumption according to an embodiment.
FIG. 18 is an example visualization of a year-by-year comparison of savings in closed hours at a site according to an embodiment.
FIG. 19 is an example visualization of upper and lower limits of baseload over multiple years according to an embodiment.
FIG. 20 is an example visualization of ratios of open hours to closed hours over multiple years according to an embodiment.
FIG. 21 is an example visualization of a percentage of open hours per day over multiple years according to an embodiment.
FIGS. 22-24 are example visualizations of load start time over multiple years according to an embodiment.
FIGS. 25 and 26 are example visualizations of decrease end time over multiple years according to an embodiment.
FIGS. 27 and 28 are example visualizations of regression models according to an embodiment.
FIG. 29 is an example visualization of a decomposition of components for use in a component analysis according to an embodiment.
FIG. 30 illustrates multiple example energy usage curves for identifying patterns among closed days according to an embodiment.
FIG. 31 illustrates multiple example energy usage curves for identifying patterns among holidays according to an embodiment.
FIG. 32 illustrates multiple example energy usage curves for identifying patterns among open days and their closed hours according to an embodiment.
FIG. 33 illustrates multiple example energy usage curves for identifying patterns among inconsistent baseload levels according to an embodiment.
FIG. 34 is an example visualization comparing a cluster of energy measured values before and after applying normalization according to an embodiment.
FIG. 35 is an example visualization of statistics applied to a cluster of energy measured values according to an embodiment.
FIG. 36 is an example visualization of the cluster of FIG. 35 compared to a yearly model according to an embodiment.
FIG. 37 illustrates multiple example energy usage curves for identifying patterns among calculated and worst cumulated savings of open days according to an embodiment.
FIG. 38 is an example heat map visualization illustrating which periods may be in baseload according to an embodiment.

Corresponding reference characters indicate corresponding parts throughout the drawings.

### DETAILED DESCRIPTION

The features and other details of the concepts, systems, and techniques sought to be protected herein will now be more particularly described. It will be understood that any specific embodiments described herein are shown by way of illustration and not as limitations of the disclosure and the concepts described herein. Features of the subject matter described herein can be employed in various embodiments without departing from the scope of the concepts sought to be protected. Any mentioned time reference such as day can be extended to any period such as week(s) or seasons or half-days or night to night or any time cut with sliding references.

The present disclosure relates generally to analyzing energy consumption data of a site and/or building and taking action to increase the energy efficiency of that site and/or building. There is a need to provide accurate, real time, and/or historical energy consumption data that is localized to a facility, a building in a facility, a floor within a building, different loads and/or another metered site. Common energy usages in buildings include temperature control for occupants, which is directly related to outside weather conditions and is often seasonal. Common energy usages in buildings also include lighting control for occupants and security (e.g., parking lots, surveillance), which is directly related to daylight hours and is often seasonal. The present disclosure provides methods and systems for detecting and alerting whether a device or an appliance, such as a heating, ventilating, and air conditioning (HVAC) system was left running when it should or could have been off. The present disclosure also provides methods and systems for identifying whether there were factors that caused abnormal energy consumption on a given day or any time period. The present disclosure provides methods and systems that are useful for providing actionable recommendations to a user to increase energy consumption efficiency. In an embodiment, a plurality of meters in a site and/or building allow a user to see which metered device or set of devices is in need of energy efficiency improvement or corrective action. The present disclosure provides for dynamically modeling the normal energy consumption (or power consumption) behavior of a process or of a building or of one of their specific components (for example, a light on a specific floor that follows external daylight hours changes over the year) on a per meter basis.

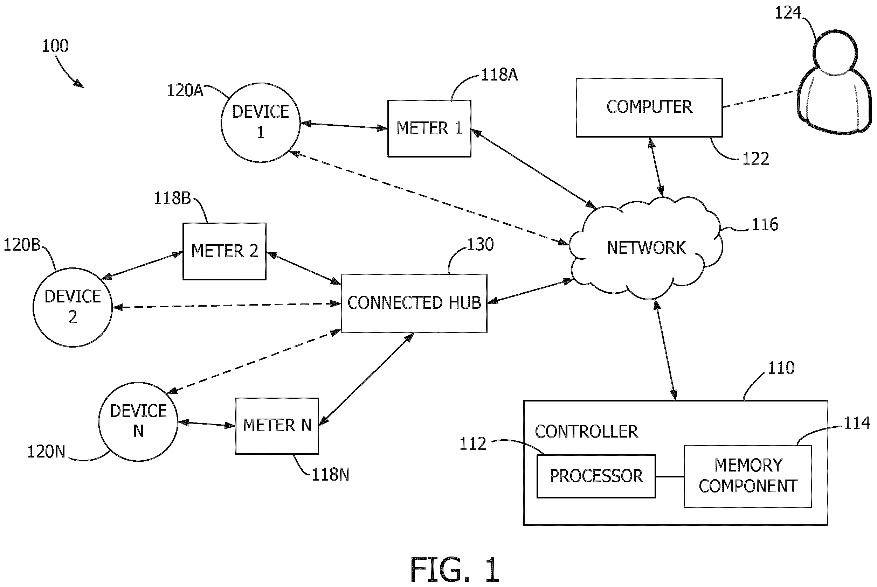

A method of the present disclosure can be implemented on a system of components (such as energy meters) connected over a network. In FIG. 1, a controller 110 includes a processor 112 and a memory component 114, and the processor 112 is configured for performing one or more of the processes described herein. The controller 110 is connected to a network 116. Energy usage meters 118, indicated 118A, 118B, ... 118N in FIG. 1, are in communication with the network 116, and can communicate with the controller 110 through the network 116. More or fewer than three energy usage meters 118 may be provided in some embodiments. The energy usage meters 118 collect energy usage data for a site (e.g. each collects energy usage data from a respective device 120, indicated 120A, 120B, ... 120N in FIG. 1) and transmit the data to the controller 110 through the network. In an embodiment, meters 118 are embodied by intelligent electronic devices (IEDs) capable of sampling, sensing, or monitoring one or more parameters (e.g., power monitoring parameters) associated with devices 120 (also sometimes referred to herein as loads, equipment, or apparatuses). It is noteworthy to understand that a Meter (M) may measure several Devices (M1, M2, M3, ... Mn).

The devices 120 can be in communication with the controller 110 through the network 116 and can be controlled by one or more signals transmitted from the controller 110. A computer or another electronic device 122 can be in communication with the network and has a user interface that allows a user 124 to view information provided by the processes of the method of the present disclosure. To manage energy consumption of devices 120, the computer 122 includes a user interface that allows a user to send commands to the controller to affect the operation of these devices (e.g. shut them off, decrease their energy consumption, etc.). In some embodiments based on data received and analyzed, the controller may take action to control one or more devices. In other embodiments, meters 118 may be indirectly communicatively coupled to network 116 via, for example, an intermediate device such as a connected hub 130 (cloud-connected hub or any other aggregator such as a gateway, or an edge/on-site software system for example) providing meters 118 with access to network 116, controller 110, and computer 122.

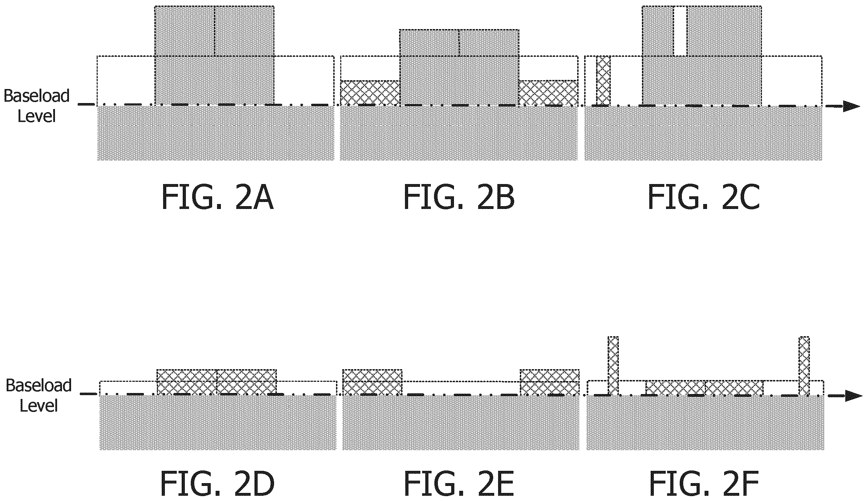

FIGS. 2A to 2F are simplified diagrams illustrating examples of the same daily energy consumption but presenting different energy consumption management issues. In these examples, FIGS. 2A, 2B, and 2C represent open days (e.g., regular weekdays) and FIGS. 2D, 2E, and 2F represent closed days (e.g., weekends and holidays). A baseload level of consumption, as described more fully below, is shown for each of the figures and constitutes in this exemplary illustration the primary characteristic for identifying over consumption and managing energy usage.

For open days, FIG. 2A shows the bulk of energy is consumed during regular running hours (e.g., during the work day), FIG. 2B shows over consumption outside of running hours (e.g., during night hours), and FIG. 2C shows the bulk of energy is consumed during regular running hours with a spike during the night. For closed days, FIG. 2D shows over consumption during normally closed daytime hours, FIG. 2E shows over consumption during normally closed nighttime hours, and FIG. 2F shows some over consumption during the normally closed daytime hours plus spikes during the nighttime hours. These examples show the importance of analyzing measurements at a higher rate (e.g., 15 minutes logged interval measurements) than daily aggregated values, which would have exactly the same energy consumption for each of the open days, and for each of the closed days. While the daily sum consumption is the same in these example figures when comparing different open days and is the same in these example figures when comparing different closed days, each of the situations presents a different issue and gives rise to specific and different recommendation(s).

One or more embodiments extract signals from meters 118 per metered point for each timestamp and leverage the concept of "closed hours" for creating a model determining baseload level and period to assess the impact of schedules on energy savings and for creating alarms in the event of over consumption. Closed hours include those time periods where no one is present in a building or site. For example, a typical office building will be closed at night as well as on weekends and holidays. Time periods when no public is present are distinguishable from time periods when no one at all is present (except for, perhaps, minimal staff).

In a museum, for example, no public is present during closed hours but staff is likely present before and after when the building is open to visitors. Staff may be present early (e.g., 5 am to 9 am). This is when staff arrives first and prepares the arrival of visitors. "Open hours" correspond in this example to a later period where visitors arrive, i.e., the public is present. Once the museum building is closed to the public, the staff often works without visitors (e.g., 5 pm to 9 pm). During time periods when no one (or only minimal staff, such as security) is present, the building is considered closed (e.g., 9 pm to 5 am). Even though these time periods are based on schedules, different schedules may apply each day, which creates confusion of what might be considered "closed hours." Schedule-based time periods often are only loosely correlated to the processes running in the building, as the processes may be influenced by many other factors (e.g., seasonal drivers such as outside air temperature and sun radiance, as well as usage-related drivers such as HVAC settings, user temperature comfort criteria, etc.).

Advantageously, aspects of the present disclosure distinguish between shutdown hours (process closed hours) from any user schedule (presence closed hours). For instance, the process may start hours earlier in winter to reach a set reference temperature by the expected start of operations. In another example, lights may be turned off by security personnel well after the last staff person has left the building, which could take hours with a progressive shutdown. The processes running often start earlier than any human presence, and may end sometimes earlier, sometimes later. Heating often starts earlier in the winter season to heat up the building before people arrive in the building. Similarly, lighting of a parking lot may be seasonal and/or programmed to remain on until a specified time, even if no employees are present. Closed hours may be determined even for buildings occupied at some level every single day (e.g., hotels and hospitals) because there will usually be time periods when activity is significantly diminished. This enables applying the analysis of closed hours, or shutdown hours, even to buildings that are never fully closed/empty. In these instances, the level of change may be much smaller: the ratio between the max energy consumption of the day and the shutdown hours energy consumption may be a factor of 2 or 3, while the ratio may be a factor of 6 to 8 for other sites.

In an embodiment, computer 122 (or processor 112 when embedded in a meter 118, device 120, or controller 110) executes processor-executable instructions to identify incoherences (e.g., incongruities, new patterns, outliers, anomalies, etc.) within the data. In an example, an energy management system embodying aspects of the present disclosure detected abnormally high levels of energy at 11:00 pm on a Sunday night. Identifying which sub-meter was the main source (also called "main contributor") of this new, unusual incoherence, it could be determined that someone had reprogrammed the hot water boiler to start on Sunday evening, instead of the usual Monday morning. The heating itself was the same energy consumption levels in both cases, but keeping the water hot for 6 additional hours (e.g., from 1:00 am to 7:00 am) without any users of hot water was a waste of energy. Moreover, by comparing multiple years, seasons or any similar period, one or more embodiments may find changes that result in over consumptions as well as under consumptions.

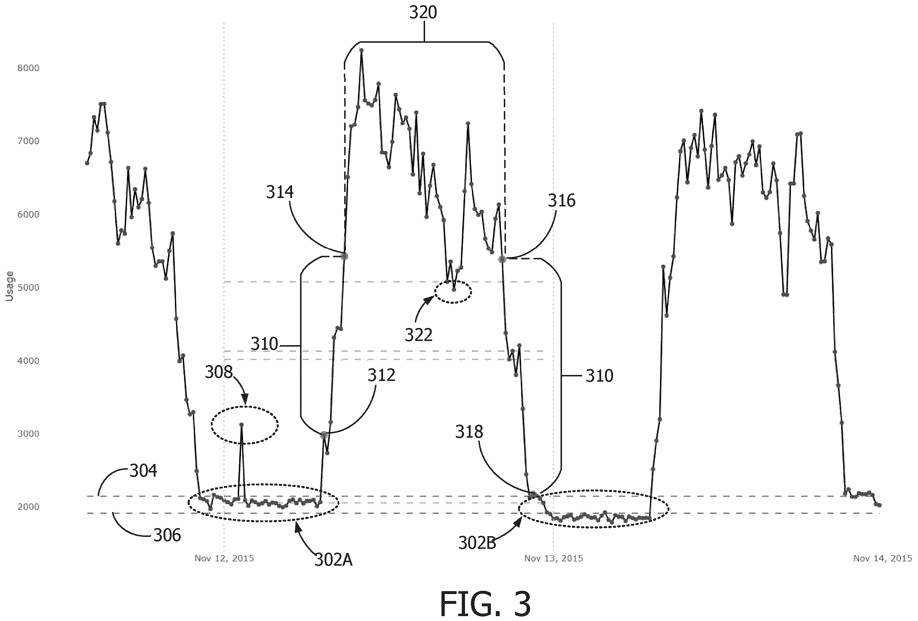

FIG. 3 illustrates an example graph tracking energy usage over a three-day period based on signals extracted from meters 118 at, for example, 15-minute intervals (i.e., 96 measurements, or timestamps, per day). The initial question is whether or not a particular timestamp is a baseload value in a baseload period. The easiest solution for determining baseload usage is to take a minimum function, i.e., MIN(), of the energy readings of each day or any period, and to simply state that this level is the "baseload." But energy consumption during the BL period has a normal variance, such as indicated at 302A and 302B, during the evening, night, and early morning period between the two days. Such variance is not represented by the MIN() value. For example, night energy consumption may vary by a certain "normal" range every 15 minutes. Also, the MIN() function does not account for outliers (e.g., occasional shutdowns for electrical maintenance of the building, or in a particular switchboard/location) or different minimum values one night to the next. As shown, the variance in BL relevant data points ranges between an upper BL candidate threshold 304 and a lower BL candidate threshold 306. FIG. 3 further illustrates other characteristics and features often found in energy usage data. For instance, the example graph of FIG. 3 illustrates a local outlier, or spike, at 308.

According to aspects of the present disclosure, baseload level is defined as the energy consumption level during normal shutdown hours, which corresponds to the periods having the lowest energy consumption. BL periods may be characterized or represented in an embodiment by a horizontal line although it is to be understood that there is a normal variance in baseload consumption. In FIG3. baseload level corresponds to upper BL threshold 304. The regression line of the BL period is generally flat because the baseload is equated to those key processes that are never turned off over several consecutive measurements (e.g., 15-minute intervals). Moreover, the BL periods are characterized by having the lowest variance compared to energy consumption during running hours that have more process running that change activity state. BL periods are further characterized in one or more embodiments by a range of normal variance (e.g., different durations of running baseload processes, such as HVAC, generate fluctuations, which create the variance). For example, the different roof top units for HVAC may run each for different durations and so the cumulative consumption will have different durations of overlapping ON time.

Compared to conventional energy management systems, the human eye is often better able to recognize patterns and identify change points in an energy usage curve. Implicitly, the human brain builds a model of what is characteristic of the BL period, identifies the change points of where the shape for a given day or time period changes, and then creates new models for this part of the shape. While the human brain can detect when energy usage moves out of baseload and back into baseload, change point detection itself is difficult when examining raw energy usage data because of normal variances and outliers in the data. Aspects of the present disclosure begin by examining what is and what is not baseload to detect obvious boundaries and changes of nature in the data. The concept of periods, shapes, and characteristics (e.g., minimum duration of a period) play key roles. For example, only part of what is not a running period (e.g., no transitions) can be considered a BL period. In addition, more steps are essential to get fine grained results. For example, identifying baseload includes detection of what are the different types of typical (i.e., normal) days (e.g., week days as either open days or closed days, with either consistent or changing durations in running hours (non BL) and shutdown hours (BL)). Identifying baseload also includes, for example detection of seasonalities (e.g., holidays, vacations, maintenance periods, periodic stock inventory nights, busy seasons, and other repetitive patterns). In an embodiment, determining what is baseload or not baseload for each day or any period and what are typical days (at a minimum, if there are open days and closed days, determining if the day is an open day or a closed day) permits the creation of simple versions of alarms embedded in the devices or gateways.

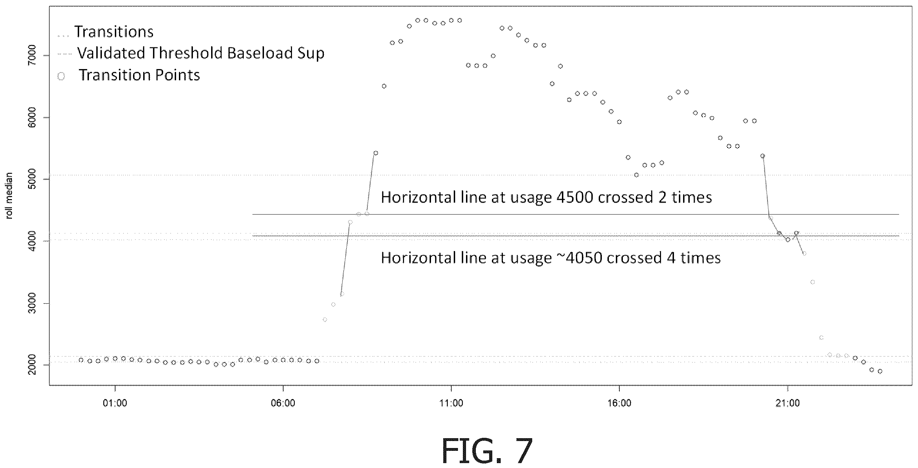

FIG. 3 further illustrates examples of transitions 310 in energy usage data. In an embodiment, a transition occurs between a BL period and a running period. The increasing transition 310 begins at a load start point 312 and ends at a load end point 314; the decreasing transition 310 begins at decrease start point 316 and ends at a decrease end point 318. In FIG. 3, a running period 320 is shown between the transitions 310 (beginning at the load end point 314 and ending at the decrease start point 316). As explained below with reference to FIG. 7, each transition 310 is detected by examining the number of occurrences when a value is crossed. A value is crossed n times, n being the number of times two consecutive smoothed values are one lower and one upper than current studied usage value. First, outliers within the BL period are not considered. Stable periods within transitions 310 are determined by the number of occurrences when a value is crossed falls over a predetermined threshold (e.g., more than two). In an embodiment, the energy signal is disaggregated into more granular categories and features (baseload, transition, running hours, stable periods during transitions, local spikes or peak periods, smoothed level, variance).

In the example of FIG. 3, load start 312 is the first timestamp on usage and/or smoothed usage that is above the baseload upper threshold 304 and above lowest transition lower threshold after BL and before high activity period that corresponds to open hours. Load end 314 is the last timestamp above the highest upper transition threshold on usage and/or smoothed usage after BL and before high activity period. Decrease start 316 is the last timestamp above the highest upper transition threshold on usage and/or smoothed usage after BL and after high activity period. Decrease end 318 is the first timestamp on usage and/or smoothed usage that is above the BL upper threshold 304 and lowest transition lower threshold after BL and after high activity period. Advantageously, identifying these points permits focusing energy analytics on baseload period(s) before load start 312 and after decrease end 318 and identify values above upper threshold 304 as overconsumption. These key change points will be more thoroughly leveraged in later sections of these applications.

Aspects of the present disclosure solve core limitations of conventional algorithms for energy management. Advantageously, one or more embodiments enable embedding into power meters 120, gateway 130, edge software executed at computer 122, and other devices/software, and they also provide more robust feature extraction and greater details/discrimination of features in the classification of energy consumption based on relatively little data (e.g., 36 hours of data to start baseload).

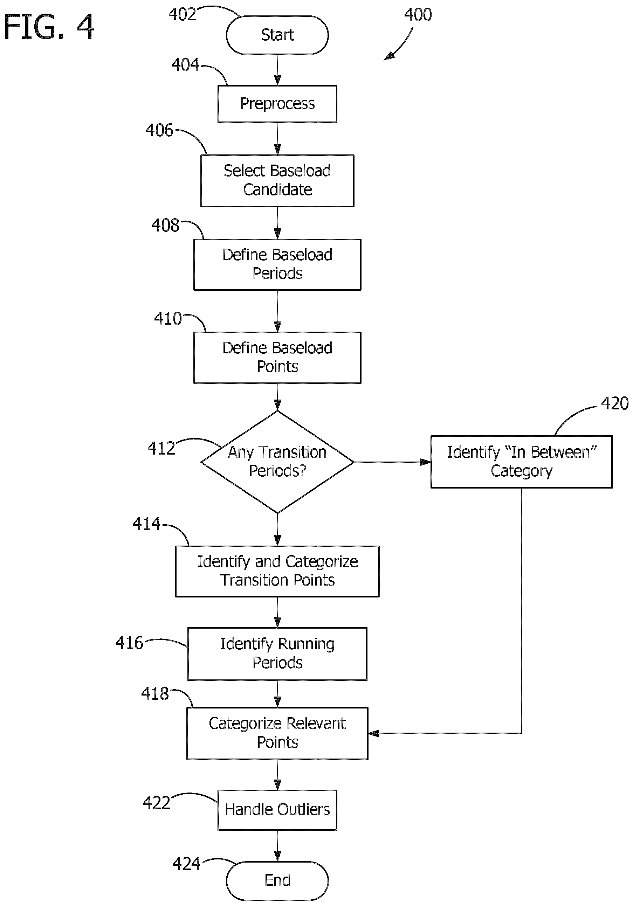

FIG. 4 provides a flow diagram of one embodiment of a process 400 embodying aspects of the disclosure for determining baseload. The process 400 extracts the energy-related data signal per metered point and, for each timestamp, creates a model representing what may or probably should be in baseload for a normal day, and creates simple alarms (e.g., per day of week) to alert of over consumptions. Before defining the structure and components of each day or any period, aspects of the present disclosure determine baseload and running periods and transition periods between the two, which involves detecting boundaries. Determining baseload also requires consideration of for example, the different types of typical days (e.g., week days as either open days or closed days, with either consistent or changing durations in running hours (non BL) and shutdown hours (in BL)), detection of seasonal effects (e.g., holidays, vacations, maintenance periods), and other repetitive patterns (such as period stock inventory nights, busy seasons, etc.).

Beginning at 402, the process 400 proceeds to 404 for preprocessing the energy usage data for a site collected by energy usage meters 118. In an embodiment, process 400 preprocesses the data by calculating several lengths of a smoothed rolling value covering a relevant period (e.g., two hours). At 406, the process selects the data points from the collected energy usage data that are candidates for classification as baseload values, for example, identifying an upper threshold (e.g., upper threshold 304) below which data points might be considered baseload values. To refine the candidates, process 400 at 406 defines adjusted upper and lower thresholds 304, 306 to account for normal variance. The relevant baseload data points are identified for different possible baseload classifications.

The process 400 continues at 408 for defining a baseload period as a function of the baseload candidates identified at 406. In an embodiment, defining a baseload period includes identifying baseload candidate periods (i.e., a sequence of data points), identifying and removing intermittent baseload period interruptions (merge baseload of before and after), and identifying candidate baseload inter periods (i.e., less significant intermediate periods between maximum of shutdown hours and minimum of running hours). In addition, defining a baseload period includes creating a new version of bandwidth (i.e., normal baseload variance between upper/lower thresholds 304, 306). Once the baseload period is defined, the baseload data points are defined at 410 for the particular baseload period. In an embodiment, defining the baseload points includes classifying each point of each baseload period, classifying each point of each baseload inter period, identifying a relevant daily time reference, inferring a typical daily model (daily features, describing/modeling the daily shape and model), characterizing each classified baseload period point and each baseload inter period point in relation to time reference(s), and identifying and tagging the points that are lower than the baseload level.

Proceeding to 412, the process 400 determines if there are any transition periods among the data points. For instance, the ramp up of energy usage in the morning and the ramp down of energy usage in the evening are typical transition periods. In a normal office building (a rule may change based on segment and building behaviors and running processes and usage) all points in between baseload periods can be selected. The transition periods are identified at 414 and the transition data points within the identified transition periods are categorized as such. In an embodiment, identifying transition periods includes calculating an open to close consumption ratio/distance, inferring or defining and then applying a step granularity, identifying and selecting daily activity points, defining the corresponding transition candidate segments for each real measured point, identifying transition candidate points, identifying and applying threshold(s) of transitions periods, and keeping only the valid transition candidate periods and characterizing each one.

At 416, the process 400 considers the periods of high activity, i.e., relatively high energy usage, as running periods and, at 418, categorizes the relevant data points as either high activity points or local outliers. On the other hand, if no transition periods are identified at 414, the process 400 identifies these "in between" data points at 420 and categorizes the relevant data points at 418 as either high activity points or local outliers when there is no transition. In an embodiment, identifying running periods and categorizing relevant points includes identifying and categorizing the high activity points, and identifying and categorizing the high activity points outliers. Identifying points in the "in between" category when no transition is identified and categorizing the relevant points includes identifying and categorizing the high activity points when there is no transition period, and identifying and categorizing the high activity points outliers when there is no transition.

Referring further to FIG. 4, the process 400 identifies outlier data points and handles them at 422 such that they do not negatively impact the energy management. Handling of outliers includes identifying local spikes (under or over), identifying any patterns of regular spikes (under or over), filtering for modeling in devices the identified local spikes, and re-injecting or using the complete data set when applying the learned model. The process 400 ends at 424.

In an embodiment, calculating several lengths of smoothed rolling period value in the preprocessing step 404 of FIG. 4 comprises setting an initial interval duration at, for example, 15 minutes and, if the utility interval is dropped to 10 minutes, considering 1.5 times the number of intervals. This aspect of the preprocessing further includes: calculating from energy measurement a smoothed long rolling value (e.g., rolling mean/median over centered 11 intervals); calculating a short smoothed value (e.g., rolling median/mean of 3 intervals); and calculating an intermediate smoothed value (e.g., rolling median/mean of 7 intervals). In this example, "long" covers a relevant period (e.g., 2 hours 30 minutes in a building, namely, 1:15 before and 1:15 after a centered (current) value).

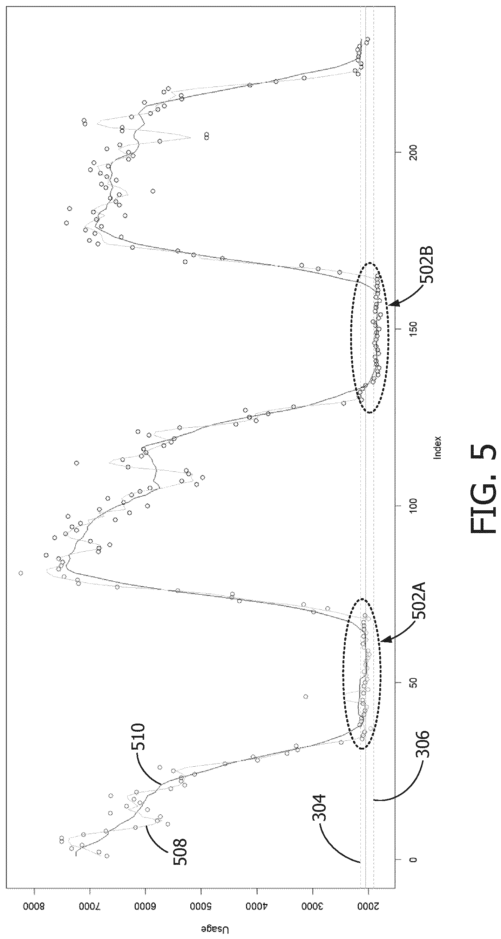

FIG. 5 illustrates an example of BL relevant data points within a normal BL variance between the upper BL candidate threshold 304 and the lower BL candidate threshold 306. FIG. 5 also illustrates an example of two baseload candidate periods 502A, 502B. As described herein, different smoothings may be employed. In the example of FIG. 5, the thresholds 304, 306 are shown relative to smoothed rolling mean short data indicated at 508 and smoothed rolling mean long data indicated at 510.

In an embodiment, first identifying a threshold of energy to select BL candidates (i.e., all values below this threshold 304) in the select baseload candidate step 406 comprises deriving value from a percentile (e.g., 10^{th} percentile, corresponding to 2h30 of 24-hour period at 15min time interval) on long running centered mean/median. In other words, the goal is to identify statistically low points during the night or any low period before an activity period, where "low" is considered the lowest 10% in a 24-hour period or in a maximum-to-maximum period. Studying the distribution by examining the density (i.e., most seen values) from the maximum point of the previous day to the maximum point of the current day permits determining whether to compute the quantile from max-to-max or based on a 24-hour period. For example, if the quantile window indicates rolling mean long values below the first maximum density value, which correlates to the baseload, then max-to-max is taken as the reference for the quantile. Otherwise, the whole day is taken as the reference period. In this example, BL candidates are first determined from the rolling mean long using a density and quantile approach. The points indicated at 502A of FIG. 5 illustrate points within a quantile window bounded by the upper and lower thresholds 304, 306. As explained below, various approaches are layered and the references change from one approach to the next to account for different edge cases. BL normal variance and upper and lower thresholds 304, 306 are taken into account for building confidence intervals. Some layers use smoothed values short or long while others use actual usage values. For instance, the smoothed density on rolling mean approach identifies which points are to be considered for normal variance and then the actual values of those data points are examined.

Also in this embodiment, defining adjusted upper and lower BL candidate thresholds 304, 306 (i.e., boundaries due to normal variance) in step 406 comprises identifying all points and classifying (tagging as baseload candidates), where the smoothed long rolling value is less than a threshold of energy to select BL candidates. This step also includes defining a normal variance of these BL candidates points and, in turn, defining normal variance thresholds 304, 306 (upper and lower limits). For example, standard deviation (SD) may be preferred to an interquartile range(IQR) calculation due to low variance of BL period to avoid having 0 as the variance for several consecutive equal values. Defining the adjusted upper and lower BL candidate thresholds 304, 306 also includes keeping all of the BL candidate points within normal variance when using the real energy values (and not smoothed long rolling value). This includes removing all points that are below normal variance (i.e., all points where energy is less than or equal to normal variance threshold 306 (lower limits) and removing all points that are above normal variance (i.e., all points where energy is less than or equal to normal variance threshold 304 (upper limit)). Defining the adjusted upper and lower BL candidate thresholds 304, 306 in this embodiment further includes calculating a final (adjusted) BL candidate upper and lower threshold by simple statistical calculation using IQR when IQR > 0 and SD when IQR = 0. For example, a lower BL candidate boundary = Q1-coeff*IQR and an upper BL candidate boundary = Q3+coeff*IQR (e.g., coeff is a tuning parameter having a value of 3). Q1 for lower and Q3 for upper boundaries is preferred to median here as the distribution might not be symmetrical, allowing to provide a more representative interval. Although described herein in the context of one statistical approach, it is to be understood that different conditional elements or coefficients could be chosen depending on the statistical approach being used for a particular site and/or building.

In the select baseload candidate step 406, identifying all baseload relevant data points for the different possible baseload classifications comprises calculating for BL candidates points the short smoothed value (e.g., rolling median of 3 intervals) and keeping only the points where the short smoothed value is less than or equal to an adjusted upper BL candidate threshold 304. In addition, identifying all BL relevant data points includes evaluating and adding the potential "previous" or "following" points that may be missed/removed due to the mechanical smoothing of the median rolling window. Points are added where the energy value is less than or equal to the adjusted upper baseload candidate threshold 304. In FIG. 5, the BL relevant data points are shown at 502A.

In an embodiment, identifying baseload candidate periods (conditions for a period is successive occurrences of similar state) in the define baseload periods step 408 comprises: identifying a potential START of all BL candidate periods using a condition, such as a forward looking rule of MIN(4 out of 6 consecutive points) needed to be BL relevant data points; and identifying a potential END of the BL candidate period using a condition, such as a backward looking rule of MIN(2 out of 4 consecutive points) needed to be BL relevant data points. In this embodiment, identifying BL candidate periods in step 408 also includes: swallowing and extending each period to adjacent points complying to the above conditions; keeping only a relevant couple of points (e.g., START and END); and removing every potential period identified above when not meeting a condition to be considered a relevant period. For example, for a START, only a first (END point) is kept, as constraints of rules are less stringent on END, so the algorithm may find more potential END points than START points). Aspects of the present disclosure include applying several rules that are being combined for looking at the start of the BL candidate period and the end of the BL candidate period. One rule is forward looking and the other is backward looking in this instance to confirm that a set of points define a coherent period. Further to the example, at least one point of a BL candidate period should have its smoothed long rolling value (e.g., long rolling mean over 11 points) less than an adjusted upper baseload candidate threshold 304. In FIG. 5, for example, the points at 502A and 502B can be considered two baseload candidate periods.

Identifying and removing intermittent baseload period interruptions (in this case merging the preceding and following baseload candidate periods into one single baseload period) in the define baseload periods step 408 comprise, for example: identifying intermittent BL period interruptions by selecting points between BL periods and, if all smoothed long rolling values are less than an adjusted upper BL candidate threshold 304, then considering all of these points as part of the preceding and following BL candidate periods; and merging both the preceding and the following BL candidate periods into one single long BL candidate period. BL period interruptions are typically peaks or over consumption falling outside the normal variance but occurring within what would be considered the BL period and level.

In an embodiment, identifying candidate baseload inter periods in the define baseload periods step 408 comprises identifying the different NON BL periods as any and each period contained between two baseload periods. These NON BL periods have many different shapes, durations, max levels, min levels. For this reason, another distinction may be made, namely, the goal is to separate real significant running periods from the less significant inter periods. Identifying candidate BL inter periods in step 408 also includes calculating for each NON BL period, if greater than or equal to 25% of the smoothed long rolling value (e.g., rolling mean of 11), are less than adjusted upper BL candidate threshold 304. If true, then the period is classified as a BL inter period; if false, then the potential period is in an operating state (class defined in a later step).

Creating a new version of bandwidth of normal baseload variance upper/lower thresholds 304, 306 in the define baseload periods step 408 comprises, for example, selecting all data points that are classified in the validated BL periods and, using these points, calculating the normal variance of the BL points. In addition, this step includes calculating validated (readjusted) BL upper and lower thresholds 304, 306 by simple statistical calculation using IQR or SD. For example, the more robust IQR is used when IQR>0 and 1*SD is used when IQR=0. A lower BL candidate boundary is Q1-coeff*IQR and an upper BL candidate boundary is Q3+coeff*IQR (e.g., coeff=3, but could be 1.5) in this example.

In an embodiment, classifying each point of each baseload period in step 410 is based on, for example, BL_INF (baseload inferior) are all points in the BL period having energy values less than the validated (readjusted) baseload lower threshold 306 and BL_SUP (baseload superior) are all points in the BL period having energy values greater than the validated (readjusted) baseload upper threshold 304. In this embodiment, BL includes all points having energy values between the validated (readjusted) baseload upper and lower thresholds 304, 306. BL_INF points have values occurring within the BL period but falling below the lower threshold (e.g., threshold 306) and BL_SUP points have values occurring within the BL period but rising above the upper threshold (e.g., threshold 304).

Classifying each point of each baseload inter period (e.g., see 502B of FIG. 5) in the define baseload points step 410 is, for example, based on BL_INTER_INF and BL_INTER_SUP. Similarly, BL_INTER_INF are all points having energy values less than the validated (readjusted) BL lower threshold 304 and BL_INTER_SUP are all points energy values greater than the validated (readjusted) BL upper threshold 304. BL_INTER in this embodiment includes all points having energy values between the validated (readjusted) BL upper and lower thresholds 304, 306. Various statistics may be computed on the BL_INTER PERIOD such as minimum and maximum values, percentile per category, length of the period, representative value, representative rolling mean value, differentiating two consecutive periods, etc. Advantageously, a typical daily model can be inferred based on, for example, a density analysis comparing a previous day to a current day or any similar day.

Identifying relevant daily time reference in the define baseload points step 410 comprises identifying the different possible daily time reference candidates and selecting the best single or multiple daily time reference(s). In an embodiment, the daily time reference candidates are daily statistical values with their respective timestamps, including extreme daily values such as MAX and MIN energy values and different percentiles (e.g., Q1, Q2, Q3, 10th, 90th, etc.). Selecting the best daily time (or any relevant period) references includes identifying relevance for the different calculated periods (e.g., what best represents each period (example of baseload period(s) model) and what best separates different periods (example of change points between periods)?).

Inferring a typical daily model in the define baseload points step 410 comprises, for example: calculating the relevant daily analysis; and inferring the relevant daily features and describing/modeling the daily shape and model. Relevant daily analysis includes, for example, a density distribution of energy consumption on a day, a previous day, a following day, etc. based on the different smoothed rolling period values, or a number of different periods, patterns of reoccurrences per type of periods, sequences of periods, etc. Inferring the relevant daily features includes, for example, analyzing the bumps of the density distribution of the rolling mean long on extended to 72 hours of energy consumption measurement: Is the BL density bump very high and narrow (this means there is probably a real baseload period, with sufficient BL points (height), with little variance)? Is there one or multiple bumps with higher than baseload value? What is the ratio of the following bumps (example of middle value of bump / highest BL value)?

Commonly assigned U.S. Patent No. 10,120,353 and U.S. Patent No. 10,921,762 disclose seven exemplary categories of energy usage. Each category is automatically calculated for each day. These categories are bins of values on the energy consumption axis ("usage" may be mean or sum for each data interval, may be kW or kWh). For example, six thresholds separate seven categories. Category 1 (CAT1) has a threshold above which a data point would be classified into Category 2 (CAT2). Each of Categories 2, 3, 4, 5, and 6 have upper and lower thresholds. Category 7 (CAT7) is defined for all data points above the CAT6 upper threshold. These categories are adapted each time the model is updated (such as daily or real time at each new reading/measurement), so as to adapt to slow changes or to detect abrupt changes. CAT1 includes abnormally low power consumption values in a given day (i.e., below CAT2). CAT2 spans a power consumption range that includes the baseload data points 302A in FIG. 3 and data points 502A in FIG. 5 (e.g., similar values around the 10th percentile). CAT2 includes normal "full off" power consumption data points. CAT1 and CAT2 are the categories of data points that make up the shutdown or closed hours meta category. CAT3 spans a power consumption range that includes transition data points 310 in FIG. 3. CAT3 is the category of data points that make up the ramp up/down meta category. CAT4, CAT5, and CAT6 make up the running hours meta category shown at 320 in FIG. 3. In an embodiment, CAT4 is a flexible or "floating" category that can be linked to either the ramp up/down meta category or the running hours meta category, as needed. CAT3 and sometimes CAT4 or even CAT5, as described below, may include values in the band that is crossed two times or more than two times, respectively. CAT4 may be the second bump, above the baseload bump, in a density distribution where 3 bumps are visible. CAT5 includes outliers between CAT4 and CAT6. CAT7 includes abnormally high (abnormal peak) energy consumption values in a given day (e.g., these may be values in the band that is crossed two time starting from max usage).

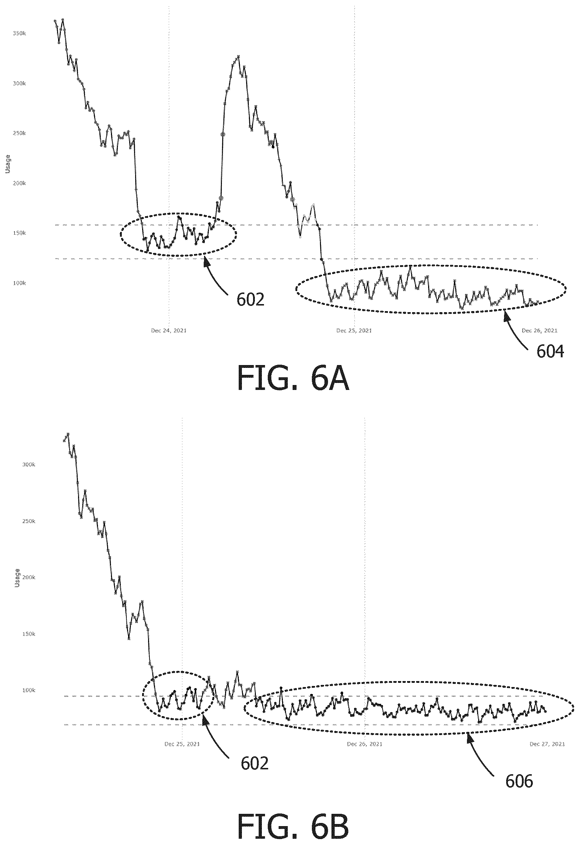

FIGS. 6A and 6B illustrate the impact of a night reference. For example, FIG. 6A illustrates exemplary energy usage on December 24th when the building is initially open but then closed overnight for the holiday. FIG. 6B illustrates exemplary energy usage on December 25th when the building is completely closed for the holiday in which case the daytime hours experience essentially the same usage as the previous night, i.e., at the baseload level. The points indicated at 602 are BL points for December 24th in FIG. 6A and BL points for December 25th in FIG. 6B. Because of the upcoming longer 1-week holiday and electrical maintenance period scheduled in the energy management system, usage is much less overnight than the normal baseload level, as indicated at 604 as CAT1 points. In the define baseload points step 410, an example of characterizing each classified baseload period point and each baseload inter period point in relation to time reference(s) includes classifying into BL_RIGHT all BL points that have a time stamp after the maximum of the day, using a single and simple daily statistical MAX VALUE TIMESTAMP as a reference. Applying the same thresholds, the points indicated at 606 of FIG. 6B are BL_RIGHT points.

In an embodiment, another example leverages the previously calculated daily density distribution and its analysis to infer multiple relevant time references by: finding all local MIN and MAX of the density distribution of the rolling mean long; calculating the threshold of density statistics relevance based on statistical values, such as 25% of the maximum density of the day; applying this threshold of density statistics to distinguish between the relevant local MIN and MAX values, and keeping only those values above the threshold; identifying the first point in day or time period (timestamp) where the rolling mean long is less than a first local maximum of density (use this as a relevant first time reference); and identify the point that is a maximum of rolling mean long appearing time stamp-wise after this first time reference. If there is no first point, the first time stamp of day can be used as the relevant first time reference (includes all data points of day in following step). The goal is to separate the day into all periods appearing before the maximum of density of density of running hours which occur after a baseload period. For instance, the energy management system has the current and previous days' data and classifies the points based on the models that were defined on the previous night. Moving to the next day, the system examines the data that was available until midnight, plus the new data until midnight again. It is important to understand that the system can compare classification of the current data and then may see if there are changes between one day and the other or previous day(s) and real time data.

In an embodiment, identifying and tagging the lower than baseload points in the define baseload points step 410 include identifying all the BL points that have an energy consumption of both measured ("raw" or "usage") energy values less than the validated (readjusted) BL lower threshold 306 and short (mean) smoothed value less than the validated (readjusted) BL lower threshold 306. If both are true, then the points are reassigned to a new class, referred to as CAT1. As described above, CAT1 includes abnormally low power consumption values in a given day, such as shown at 604 in FIG. 6A. The rationale is to identify BL values that fall into lower than normal BL values, which is not due to local variance of a single point. If both are not true, then the BL_INF classification is kept, which represents single values of baseload due to probable abnormal local variance.

As described above, transitions refer to changes from the state of closed hours (baseload period) to open hours (running or activity period) and vice-versa. In the identify transition periods step 412, examples of calculating the usage open to close ratio/distance include leveraging the previously identified periods, calculating the 72-hour (or daily) statistics of the BL periods and running periods, and calculating the distance between these two groups. In these examples, the median of all points of the BL periods, as well as the median of the running periods, are calculated per day (either as a value (running period level - BL period level) or as a proportion (running period level / BL period level)). Other examples do not require the identification of periods, including the distance between statistical distributions based on percentiles (percentile 95% of all values - percentile 5% of all values), the distance or proportion leveraging previously calculated values (e.g., 72-hour maximum point vs. 72-hour BL upper threshold 304), and the distance between the maximum of smoothed long rolling value over 72 hours and the 10th lower percentile. In an embodiment, a well-managed building site has a ratio of open hours over closed hours > 2 for open days, wherein the ideal ratio for a closed day is close to 1. This concept permits determining activity level per day / period. For example, the system can send an alarm / notification to identify worst closed days, best open days as reference, half closed days, etc.

Defining the corresponding transition candidate segments for each real measured point in the identify transition periods step 412 comprises, for example, creating a very small virtual segment based on the virtual previous and following value (real energy usage -1 and real energy usage +1) for each point. This +/-1 works for any range of values and supports the goal of taking the integer value +1 and -1. Each point previous points with their rolling median short.

FIG. 7 illustrates one example of identifying transition candidate points in the identify transition periods step 412. In this embodiment, identifying transition candidate points comprises calculating, for each virtual point, the crossing count, which is the number of times the different rolling mean short crosses this value and tagging all points where crossing count is MAX = 2 (one crossing as slope is going up, one crossing as going down) as transition candidate points. Another example of identifying transitions periods in step 412 according to this embodiment is leveraging open to close usage ratio/distance, and applying a predefined level such as 60%, which defines an upper transition level. This may be calculated per day, or over multiple days/periods (e.g., a seasonal or yearly threshold). Another example of applying threshold(s) of transitions periods in step 412 according to this embodiment is removing all the points that are considered as normal running activity (above the upper transition level) from the transition candidate points.

In the identify transition periods step 412, keeping only valid transition candidate periods and characterizing each one comprise, for example: leveraging the boundaries of each period of transition candidate points as well as all the "not transition" virtual points (where crossing > 2); defining a lower transition threshold (i.e., lower boundary of transition); defining an upper transition threshold (i.e., upper boundary of transition); and identifying all transitions that have a minimal distance condition to next transitions. For example, transition candidate periods are kept only if the distance to the next transition points is greater than a step granularity. An example of applying the step granularity in step 412 includes applying a predefined percentage (e.g. step granularity 5% of normal daily range) on the above distance (per day, calculated on 72-hour sliding window) and inferring a more global distance (e.g., values based on sliding quarter, or yearly distance calculations). Categorizing the transition points includes identifying and characterizing each period between transitions periods, identifying sequences of between transitions periods, identifying outliers, categorizing each point of each sequence of between transitions periods, and grouping consecutive transition periods and categorizing each point of each transition period. In this exemplary illustration, the concept of transition is based on number of times a value is crossed. Because the values are continuous, a granularity step is used to define a valid and sufficient usage interval on the y-axis (i.e., usage), which imitates what corresponds to a visible range of values for the human eye (e.g., 1/30 * Percentile 97.5% - Percentile 2.5% on usage). If no step is defined in the example, between 0 and 1 there is infinity of points and the distance is 1, wherein 1 over 1 million is insignificant while 1 over 5 is significant, meaning that a transition would have been found in between each point.

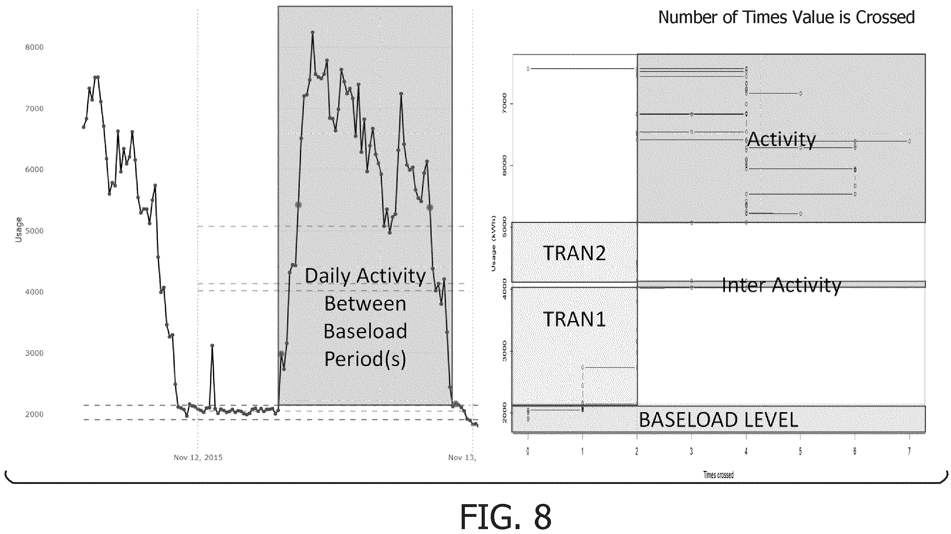

FIG. 8 illustrates an example of identifying and characterizing each period between transitions periods in the categorize the transition points step 414. In an embodiment, this step comprises identifying all periods in between transition periods (i.e., segments) between valid transition candidate periods and adding the period from BL upper threshold 304 to a first transition. For each one of these, this step also includes identifying points in a day that have rolling median short inside between transitions periods. A special case exists where a single point is categorized as TRAN k, where k is the in between transition number. A categories number can be counted from lower median values to upper values (usage reference) or from lower timestamp to biggest timestamp (time reference). Each one of these has a LOWER_BOUND and UPPER_BOUND defined (i.e., minimum threshold and maximum threshold) derived from the above step.

In an embodiment, identifying sequences of between transitions periods in step 414 includes defining the logic(s) of application of category identification and definition and identifying all points that are points included in between transition periods, such as all points for which an energy measured value (i.e., usage) or rolling median short are inside thresholds defined (LOWER_BOUND and UPPER_BOUND). In addition, identifying sequences of between transitions periods includes identifying all sequences of consecutive points included in between transition periods (e.g., if "has at least one consecutive point") and extending sequences to adjacent points that should be incorporated into sequence due to their proximity in terms of energy values. Sequences can be extended by, for example, identifying the points that have their rolling median_short very close to the sequence bounds using a variance indicator to extend the thresholds defined (subtract/add local standard deviation to LOWER_BOUND and UPPER_BOUND). Many other methods of determining transition points may be used. Just for illustration purposes, another example may be based on density distribution (e.g., analyzing and then classifying potential transition points situated in between the baseload points and the high running hours bumps).

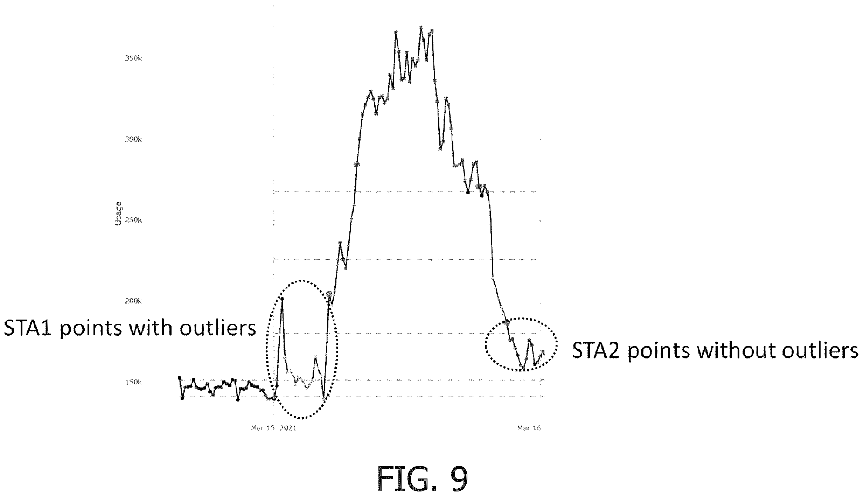

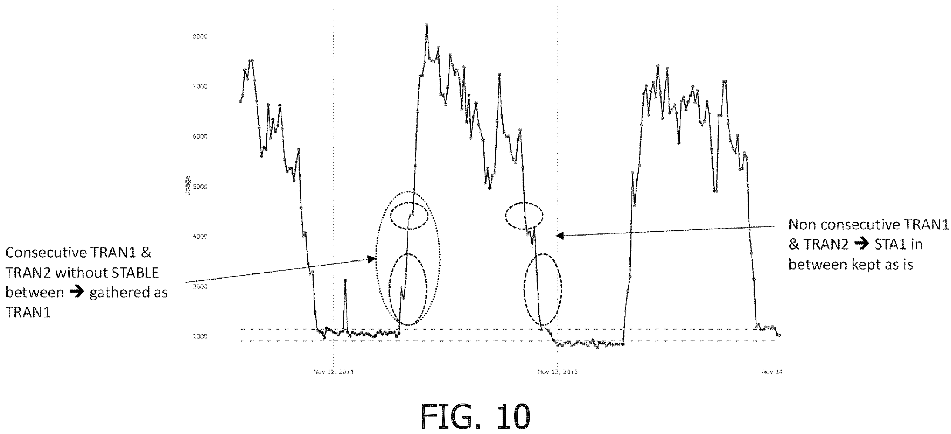

Referring now to FIG. 9, examples of stable sequences of points in transition periods are shown. Stable points correspond to inter activity hours that remain consistent for a long enough time interval. Identifying outliers and categorizing each point of each sequence of between transitions periods in the categorize the transition points step 414 comprise defining the normal variance of each sequence (using one of the previously variance calculations) and categorizing each of the values (within the normal variance as STA_xxx and outside the normal variance as OUT_STA_xxx). In this example, "_xxx" is the incremental number of sequences (according to the above defined logic, such as from left to right numbering. FIG. 10 illustrates an example of grouping consecutive transition periods, depending on whether or not the energy usage data includes a stable period between transition periods. Grouping consecutive transition periods and categorizing each point of each transition period in step 414 comprise, for example: grouping consecutive transition periods (e.g., if not interrupted by any stable period (including their potential outliers), then group these consecutive transition periods together); numbering each transition period (where "_xxx" is the incremental number of sequences (according to the above defined logic, such as from left to right numbering); and identifying and categorizing each of the points of each of the transition period by adding the incremental numbering (TRAN_xxx).

In an embodiment, identifying and categorizing the high activity points in the identify running periods and categorize relevant points steps 416, 418 include, for example, selecting all points that do not have any categorization or are in the transition (TRAN_xxx). In this example, usage (measured energy) is greater than MAX(upper transition thresholds). Because there is often more than one transition period, MAX(all) is selected. Categorizing each point as CAT>=4 identifies very short drops into transition or into BL (as being outliers) due to the smoothing in transition identification. Identifying and categorizing the high activity points outliers in steps 416, 418 include categorizing each point as OUT_CAT>=4, which identifies very short drops into transition or into BL (as being outliers) (see, for example, a local outlier 322 in FIG. 3). For example, all points may be selected that are either CAT>=4 or TRAN_xxx, using the rolling median short is greater than MAX(upper transition thresholds). Again, there is often more than one transition period, so select MAX(all) is selected corresponding to the highest usage level found. In the example of outlier 322, usage (measured energy) is less than MAX(upper transition thresholds).

When identifying and categorizing the high activity points when no transition period in the identify in between periods and categorize relevant points steps 420, 418, each point is categorized as CAT>=3. For example, all points that do not have any categorization (not BL related so no BL, BL_INTER, OUT_BL, or CAT1 points) may be selected. In this example, measured energy usage is greater than (validated (readjusted) BL upper threshold 304) and rolling mean short is greater than (validated (readjusted) BL upper threshold 304). Identifying and categorizing the high activity points outliers in steps 420, 418 includes, for example, categorizing each point as CAT>=3_INF that does not have any categorization.

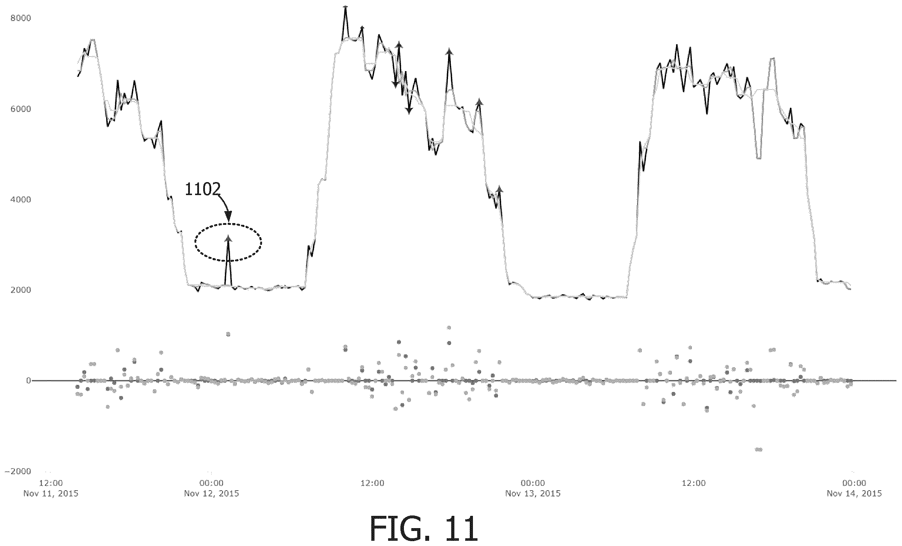

In an embodiment, a local spike 1102 is shown in FIG. 11 on an exemplary smooth long rolling energy usage curve. It is to be understood that spikes are local outliers that occur over (i.e., markedly greater consumption) or under (i.e., markedly less consumption) on the energy usage curve. Identifying local spikes under and over in the outliers handling step 422 comprises, for example: calculating a smoothed long rolling value from energy measurements (e.g., rolling mean/median over centered 7 intervals, covers 45 minutes before and after); calculating a difference between usage (measured energy) and smoothed long rolling value "diff to smoothed", which represents a gap between raw values and typical local values; defining normal variance of these "diff to smoothed" values (e.g., standard deviation may be preferred to IQR calculation), including defining normal variance thresholds (upper and lower limits); and identifying "spike over" and "spike under" points (i.e., points outside "normal variance thresholds (upper and lower limits)" and the direction flagged to know the impact on energy consumption). Such points are identified and filtered from the spike models with constraint on variation percentage above a threshold (e.g., 10% to avoid small false or insignificant positives). In this instance, the spike 1102 is a spike over point.

Identifying pattern of regular spikes under and over in the outliers handling step 422 includes identifying spikes candidates for patterns analysis and calculating per type of spike (spike over, then spike under) if they have sufficient spikes number based on a condition (e.g., 5 spikes at 15 min interval corresponding to more than 1 hour of abnormal values in a day). For each type of spike candidates ("spike under", then "spike over"), an example of a regular pattern analysis based on time between reoccurrences comprises computing gaps between spikes and examining the gaps to identify a "most seen gap distance". If a sufficient number of gaps are at the most seen distance (e.g. more than 50% of consecutive spikes have a distance of 2 hours), then a pattern can be defined.

Aspects of the present disclosure include modeling the identified local spikes under and over in step 422 in devices, such as intelligent electronic devices (IEDs), gateways, power meters, relays, etc. If spikes are not identified and removed from the model build phase, the baseload may be identified on the spike under values, even if these spike under may appear only rarely (e.g., every 3 hours), their lower values may be sufficiently low to create a separate, low line and thus create a wrong classification of points (cluster or percentile). Leveraging the spike over and spike under points permits creating a separate learning data set that removes all of the points meeting the conditions of spikes from the original data set used for model learning / model build. Further, re-injecting / using the complete data set when applying the learned model in the outliers handling step 422 comprises applying the values from the model build phase to the complete measured data, including the spike under and the spike over points. It is often interesting to perform the analysis both on a filtered learning data set, as well as on an original complete dataset (including the spike under and the spike over points).

Aspects of the present disclosure focus on identifying regular over consumption, as well as their main contributors. Under conventional approaches, these regular, ongoing contributors can become a learned pattern such that they are considered part of the baseload and therefore difficult to identify for savings. Often, regular contributors on a day-by-day basis reveals highly granular information on over consumption occur the night before and/or at the end of day when usage would normally drop to baseload but does not.

In an embodiment, signal extraction, a first level normal behavior modeling and over consumption detection and corresponding alarming to enable advance energy analytics occurs primarily at the device and edge levels (e.g., energy metering, power quality metering, gateways, etc.) and a second level of advanced energy analytics for providing cross validated, streamlined recommendations and solutions occurs primarily at the edge and cloud levels (e.g., software-as-a-service or managed service either on site or remote).

One or more embodiments focus on calculating the baseload, inferring the open day and closed day classifications from the baseload, and generating alarms based on baseload changes (e.g. duration, level or variance). In addition, aspects of the present disclosure permit generating alarms and reports fully automatically to enable a number of energy management features, including: identifying over consumptions and determining the potential savings per day, week, month, year, etc.; determining a level of confidence for each identified potential saving; linking identified over consumptions to actionable recommendations; identifying the main sources of over consumptions and co-occurrences between meters/sources; providing a visualization that shows the end-user/customer a proof of this claim; differentiating between night and weekend savings vs. during operating of the building (i.e., "open hours"); determining repetitive over consumption patterns (peaks and spikes); avoiding confusion between the seasonal (outside temperature and daylight savings) from the over consumption thus providing realistic savings analysis and enabling actionable recommendations; analyzing multiple years of data and identifying yearly drifts; enabling multi-site comparisons; enabling alarms with actionable recommendations (on baseload, building signature, etc.); optimizing daily start and end hours adapted to current season; and predicting/defining what is normal consumption and providing transparency/interpretability. All these features calculated on many different sites and meters may then be stored in one or more data bases and used as a benchmark to evaluate any site against. This helps grow awareness of strong and weak points/features for each new building/analysis.

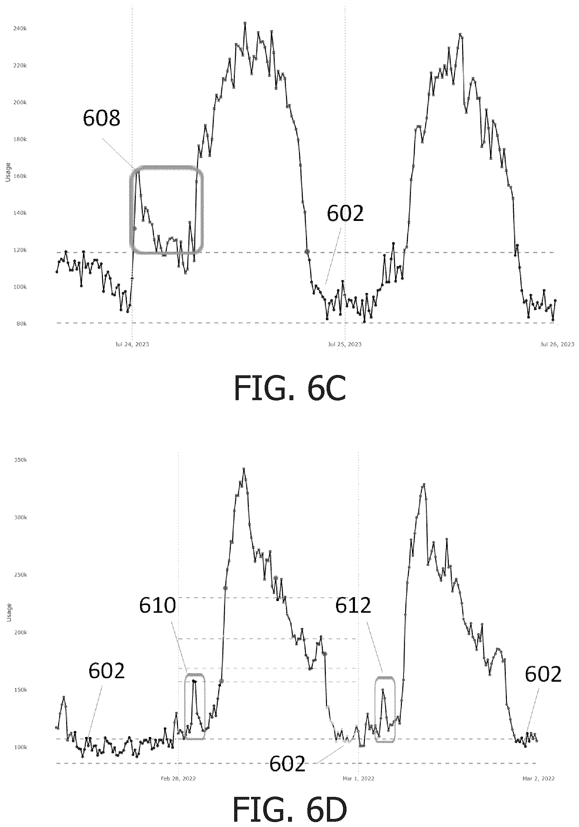

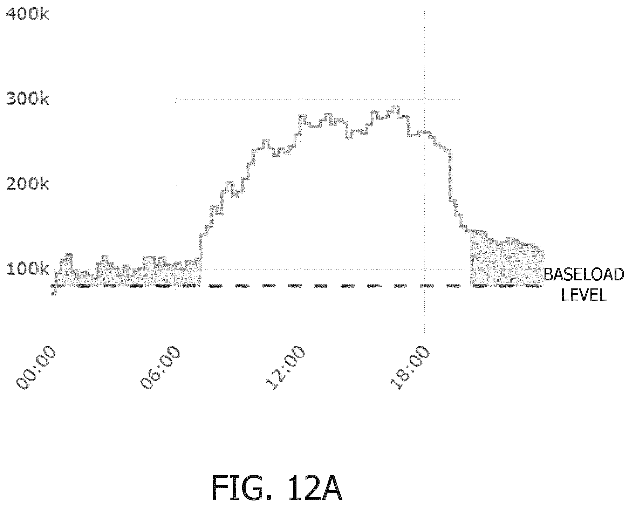

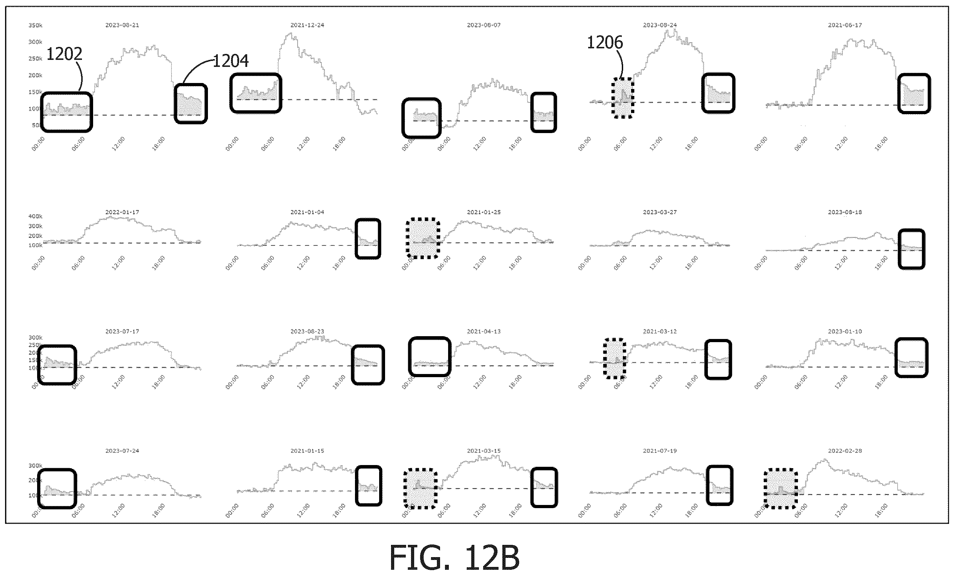

FIGS. 12A, 12B, 13, and 14 illustrate examples of energy usage curves for different time periods. In an embodiment, evaluating over consumption across several days paints a more complete and comprehensive picture of energy usage and helps identify repetitive patterns. In other embodiments, evaluating over consumption per day helps focus attention on particular cases and this may also enable a simple version embedding alarming on a daily basis into a hardware device with less calculation capabilities (e.g., a device with less RAM and processor available for energy management). In FIG. 12A, for example, an open day is shown in which the bulk of energy is consumed during regular running hours (e.g., during the work day) and the shaded areas represent shows over consumption outside of the running hours (e.g., during night and early morning hours). In the example of FIG. 12B, comparing the top 20 worst open days might exhibit repetitive patterns of over consumption before the start of the regular work day, shown at 1202, occurring on several days. This indicates equipment regularly turning ON early even though it might not be necessary during closed hours. Several of the top 20 worst open days might also show a different repetitive pattern of over consumption after the end of the regular work day, shown at 1204, which indicates equipment regularly remaining ON even though it might not be necessary during closed hours. Both of these repetitive patterns shown at 1202 and 1204 are abnormally high "constant" levels of baseload in the illustrated embodiment. This may be due to specific days such as illustrated in FIG. 6C where over consumption is illustrated at 608 versus baseload levels 602 for this day as well as for the previous and following days which both display the same baseload levels as shown at 602. Out of the ordinary repetitive patterns, indicated at 1202 and 1204, are abnormally high "constant" levels of baseload. And other patterns, indicated at 1206, may occur as "irregular spikes" (if short duration such as only 1, 2 or 3 15-minute periods) or as "peak periods" if 1h or longer, but not during the whole night or early morning (between midnight and 7am as illustrated at 1202).

An example of such an "irregular spike" is illustrated in FIG. 6D where a local spike 610 is repeated the next day at local spike 612. These may be repetitive patterns if the same shape of spikes or the same shape of peak period re-occur in several days, especially if a specific day of week displays these shapes in a repetitive way. Sometimes, these repetitive irregular patterns may even reoccur on the same time stamps. A real case example was due to the change of the boiler start period in a manufacturing and office facility where the settings were changed to restart the boiler on the Sunday evening at 11pm instead of the Monday morning at 5am. This created a peak in the night, every Sunday at 11pm continuing Monday mornings till around 1 or 2am, then dropped back to baseload level, but with a higher baseload level than before due to the boiler requiring maintaining the water at higher temperature during the rest of the night. In this instance, changing the boiler start to 6 hours earlier creates both a shape change of Sunday night and Monday morning, and generates an over-consumption of maintaining the hot water in an unnecessary way for 6 additional hours versus the previous more optimal setting. This was due to a user who wanted to guarantee hot water at setting temperature for 7 am. It would have been sufficient to move the start time to 4:30am for the coldest days, which was what done after detecting this over-consumption after analysis.

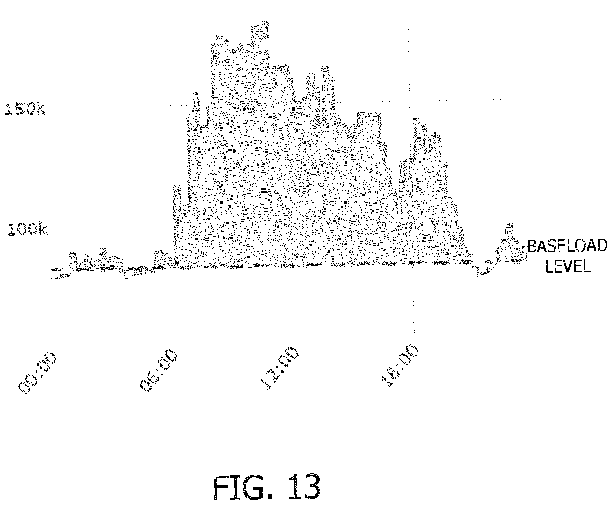

According to one implementation, the shaded area of FIG. 13 illustrates over consumption during the day hours on a closed day (here a holiday). Closed days may regularly occur on the same day(s) of week, such as typically in office buildings the Sundays, as well as maybe Saturdays, depending on local habits and rules or regulations, as well as on a national or regional holidays. It is to be understood that for a closed day, all values should (e.g., according to this example of best practices, expert rules and ECM, and best-in-class site observations) be in the baseload level range except for the normal variance for the particular site when closed.

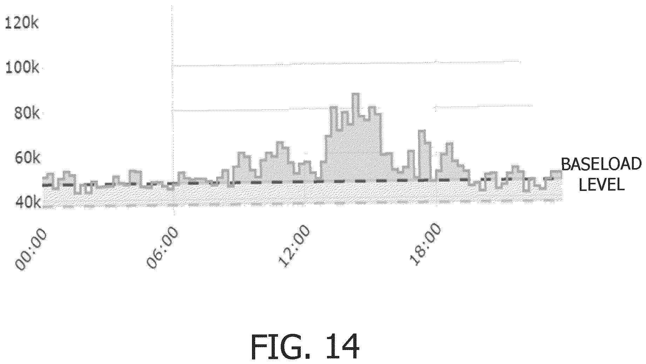

FIG. 14 illustrates a typical closed weekend day, displaying in darker shaded grey the incoherence of closed hours baseload over consumptions, as well as in lighter grey, an elevated baseload level. This second layer may appear "below the baseload" line. It will be described further in 1520.

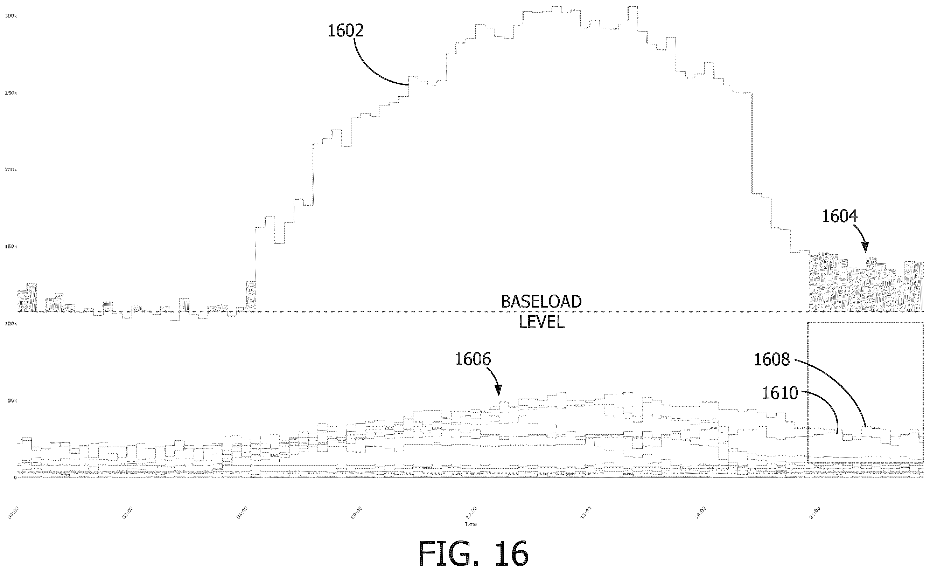

In each of these examples, the system can be configured for analyzing and visualizing multiple days of data, such as the top 20 worst open days or the top 20 worst closed days for comparison purposes as well as to reveal patterns of over consumption (e.g., regular over consumptions). In one implementation this type of analysis may be run per year, so as to track changes per year to the previous years. In other implementations the analysis may be leveraging any other period (e.g., a sliding 13 months learning period), as well as temperatures or seasons to compare and track the evolutions and identify potential patterns and visualize identified trends. Further to the example of FIG. 12B, several of the top 20 worst closed days might show recurring patterns of over consumption in the early morning, which indicates equipment regularly starting early even though it might not be necessary on a closed day. Similarly, several of the top 20 worst closed days showing over consumption during the middle of the day or at the end of the day reveals a different pattern resulting in a different recommendation. To help identify the sources of over-consumption as well as to provide the best possible insight on the causes of over-consumption and deliver the best recommendations, the system leverages any further information and measurements available, such as later described in the main meter s and sub-meters main contributors to detected over-consumption analysis described by leveraging FIG. 16 for illustration purposes.

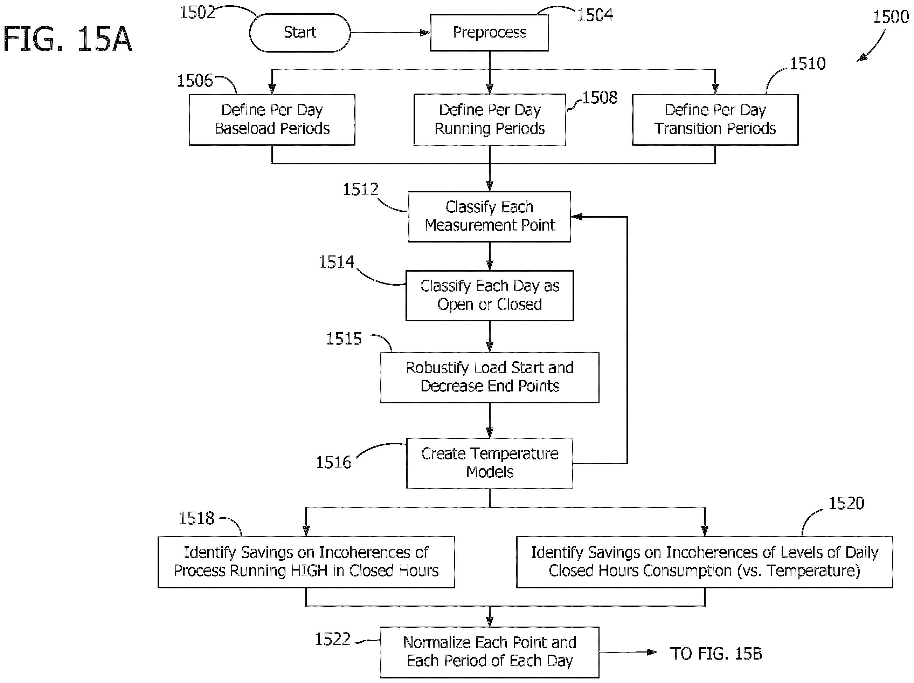

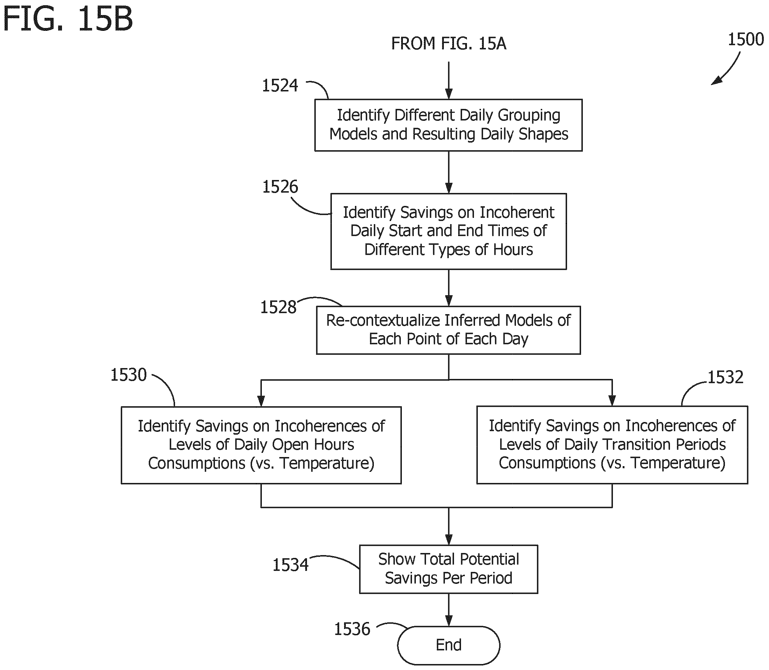

FIGS. 15A and 15B provide a flow diagram of one embodiment of a process 1500 embodying aspects of the disclosure for advanced energy analytics to provide automated and streamlined recommendations and solutions for energy management. In an aspect, overall insight(s) are added in at least one report (on all meters and leveraging the hierarchy) from top meter down to the bottom/leaf metered point for identifying main contributors to over consumptions generating alarms, adding contextual data (e.g., outside air temperature through a °F/°C regression model, wind, rain, attendance, number of visitors, number of dishes, etc.), detecting and classifying if metered point(s) are sensitive to °F/°C changes (or to any of the other contextual data which may be key "drivers of energy consumption"), creating pattern analysis (per meter, identifies for recurring over consumptions the co-occurrences of meters, etc.), identifying when a problem started occurring, showing daily as well as yearly savings or over consumptions, showing year-to-year trends, resolving edge cases and more complex outliers, etc.

Beginning at 1502, the process 1500 proceeds to 1504 for preprocessing the energy usage data resulting from execution of the signal extraction and processing described above in connection with process 400. In an embodiment, preprocessing includes cleaning the data to build robust models and remove outliers (e.g., meter roll-over going back to 0 when reaching the max numeric value of a cumulative reading of a given meter, or identifying errors due to communication when a value is totally out of range such as real case example of a single consumption interval for a medium size office building which had value at the level of a nuclear plant production for that interval), non-applicable values, calculate the normal interval duration (e.g., applying a median or min function on the duration of the main aggregated meter and for each meter) and then identify and process (e.g., filter, replace, estimate or correct) abnormal interval durations. The process 1500 then defines an initial evaluation of the baseload periods (e.g., closed hours) at 1506, the running periods (e.g., open hours) at 1508, and the transition periods between them at 1510, each on a per day basis.

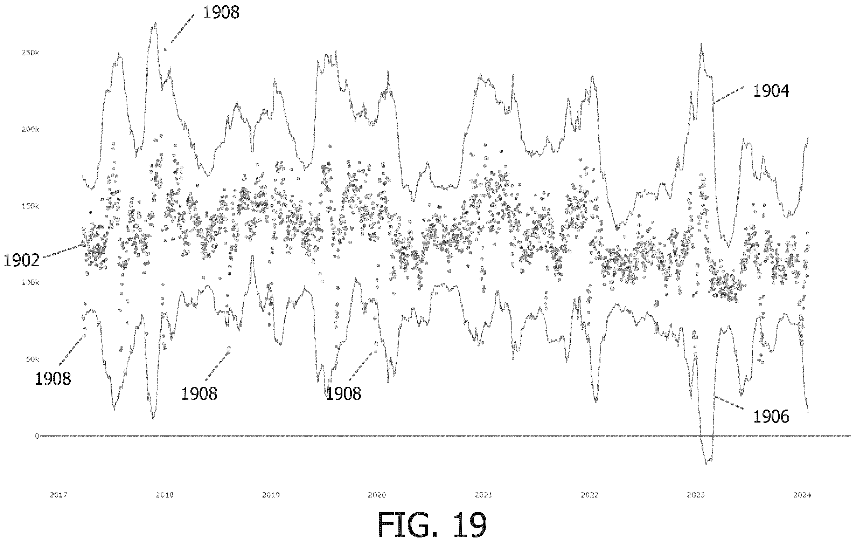

At 1512, the process 1500 revisits to validate and robustify the classification of each measurement point into its correct class (e.g., baseload, running, or transition) and, at 1514, classifies each day into an Open day or a Closed day. To classify the points, process 1500 identifies relevant rules and performs statistical tests per day and on the dataset. In one implementation, process 1500 builds a normal reference at 1512, including the acceptable variance for several of the underlying models. For example, in FIG. 19, the normal reference including the variance may be a sliding window calculation leveraging median or mean calculations based on the daily values 1902, to which is added or subtracted an accepted variance calculation (e.g., standard deviation or interquartile range) to determine an upper limit 1904 or a lower limit 1906. All of the points may be classified as "within bounds" and stay in the group 1902, or identified as "outliers" and reclassified as such as indicated at 1908. Then it is possible to process these "outlier" points, for example, by replacing their value by NA and using an interpolation between the previous and following points which are in the "within bounds" classification. It should be noted that any type of processing may be chosen, and "interpolation" may be representative of any timeseries processing techniques and methods or algorithms of NA or outlier values processing such as for example "replace by mean/median", "last value carried forward", "next value carried backward", "Imputation by Structural Model & Kalman Smoothing", "ARIMA", "Seasonally Decomposed Missing Value Imputation", or other methods and tools or algorithms which are state of the art. FIG. 19 is focused on calculating the upper daily value for the baseload. This threshold is key to identifying the value of baseload for each point per day: Is this point a baseload period point, or is it above? If above, it will need to be reclassified into transition point or running hours point. The process at 1512 likewise processes the lower threshold of normal baseload points. Any point which is below this threshold will be reclassified as CAT1, so as a category below the normal baseload level.

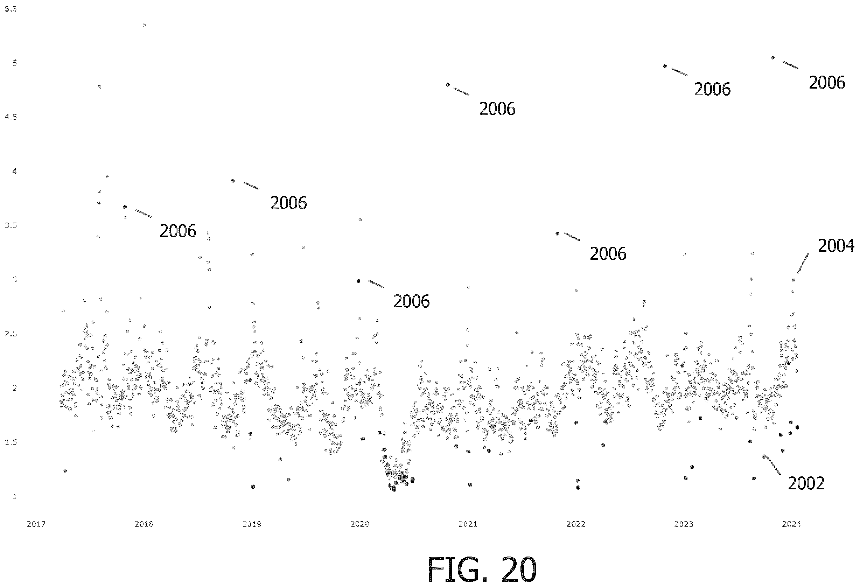

In one implementation, step 1514 calculates several features potentially characterizing an open day vs. a closed day. Step 1514 then combines these different features to determine if the day is classified as "open" or as "closed" day. Open hours and closed hours might have clearly distinct statistical populations that can be separated in two normal models. By example of features in this implementation, the system may calculate the ratio between the daily open hours to the closed hours. FIG. 20 provides an exemplary illustration. Reference character 2002 illustrates closed days correctly identified based on the open hours to closed hours ratio feature. Reference character 2004 indicates correctly identified open days, based on the open-hours to closed-hours ratio feature. Reference character 2006 illustrates the detected incoherent original classification as closed day for a day with an abnormally high ratio for a closed day. All of these points tagged as 2006 may be reclassified by this feature as a potentially open day. But such a ratio may not be sufficient by itself and may mis-classify days if taken as sole feature. Another very useful and self-explanatory feature may be the time (or number of intervals) in or below baseload level vs. the time (or number of points) in open hours or transition period (so above the upper baseload threshold re-calculated in 1512).

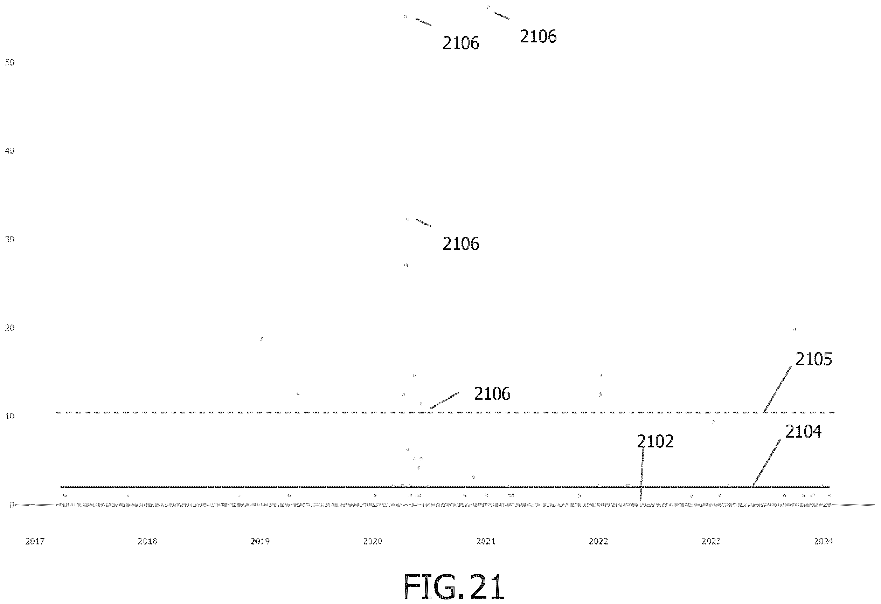

FIG. 21 illustrates an exemplary graph with a filtered dataset only on Saturdays and Sundays. It is the percentage of time spent in Open hours per day. The initial classification may have been incorrect when taking a larger view than the day of several days or week, due to some incorrect localized baseload levels. These values may be corrected in the previous steps 1512 and 1514. After these corrections were applied and after each point has been reclassified, both not open hours or closed hours, the system may recalculate the classification of the day. As may be evident, reference character 2102 shows many days (each point is a daily value) where no time is spent in open hours (0% of the time is spent in open hours) after these corrections were operated. Reference character 2104 shows the calculated threshold determining the statistical normal day threshold. Any day with a value below that threshold may be considered a closed day in this feature calculation. All points 2106 show candidates for re-evaluations of the classification into open day (instead of closed day). Reference character 2105 shows another line which may be tuned to a site or segment (e.g., education may have a different value than administrative or than office buildings). In this exemplary illustration 2.5 hours of open hours would change the classification from "closed day" into "open day" based on this threshold. It is noteworthy that each day is then reclassified into the relevant period and the relevant category based either on one discriminant feature, but may also be classified not simply based on one feature, but on these different complementary features, on rules and tests. Moreover, the rules and tests permit classifying each day as either an Open or a Closed day with much higher confidence after this robustification step where the system takes into account the context of the previous week(s), month(s) or even year(s), and when available, the following week(s) or month(s) or year(s).

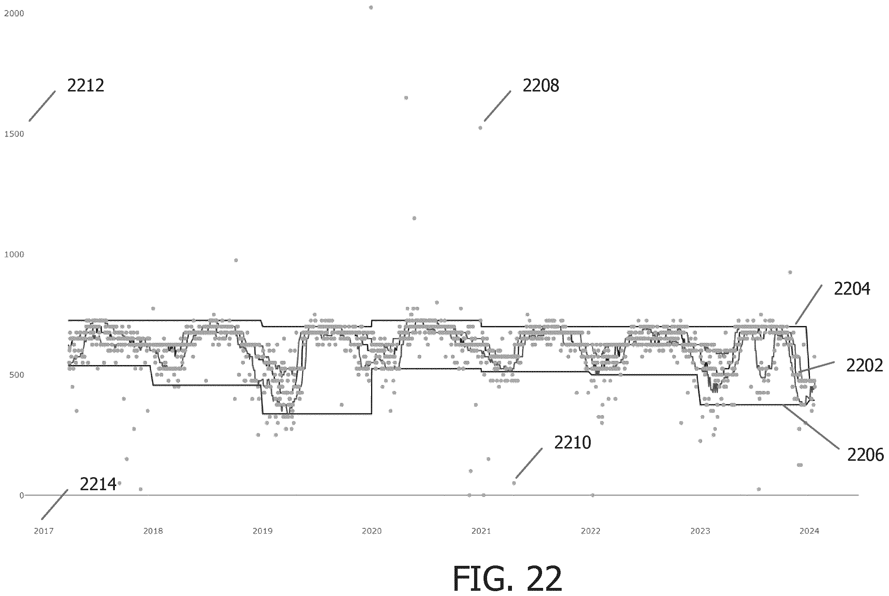

After 1514, an additional step 1515 will then robustify in a similar way the "load start" time and "decrease end" time only for the open days. These are the two fundamental change points indicating when the points exist or re-enter any baseload period(s). The load start is the inflection point illustrated by 312, and the decrease end is illustrated by 318. FIG. 22 is an exemplary illustration of one method of robustifying the load start time. The Y axis represents the time in hours 2212, while the X axis is the date (in years) 2214. Every point in the graph is a daily value of the change point of "load start". Every daily value considered a statistically "normal" point is represented as 2202 and all these daily points are included within the boundaries marked by the yearly upper limit 2204 and the lower limit 2206. As such, all points outside of the boundaries (above line 2204 or below line 2206) are thus considered abnormal, tagged as outliers, and may then be recalculated. As example point 2208 is a day where the calculated load start time was abnormally late (time is approx. 3pm), and 2210 is a day where the calculated load start time was abnormally early (time is approx. 1am). The original load start value may be stored and reused for shape analysis, while a new "robustified load start" value may be now calculated based on this abnormal time detection. This new "robustified load start" value will ensure consistency in the open days modeling of buildings. Any abnormal day may then be subjected to a specific analysis by the user or the system. This analysis may be a user validation of the abnormal days. Or it may be leveraging shape analysis of open days described in 1524 to validate the correct classification of points 2208 or 2210, as well as correct classification of the day into open day or closed day in step 1514. As described hereafter, the system may then loop back to step 1504 or to step 1512, until reaching stability.

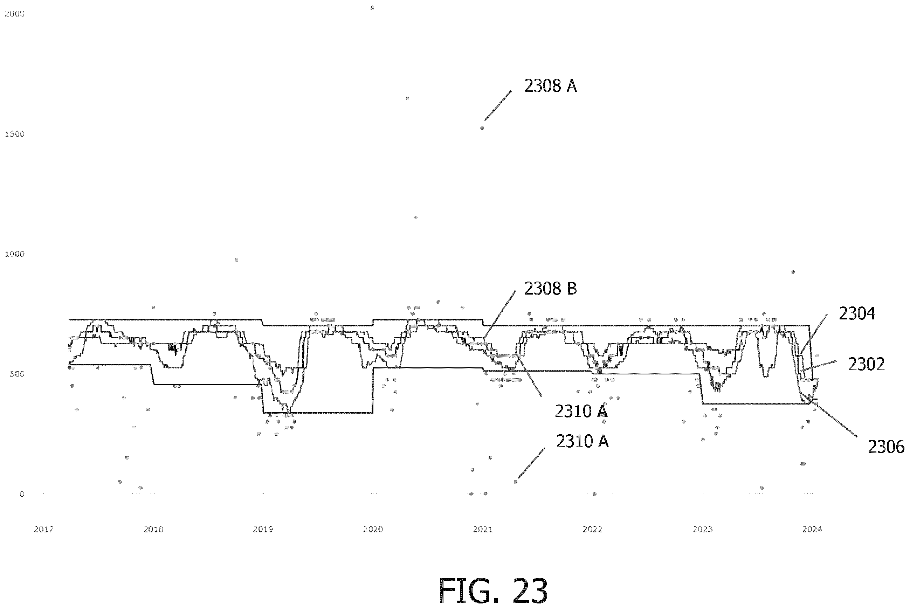

FIG.23 illustrates one implementation of a recalculation of the load start of the points 2208 and 2210. These points have an original value represented by 2308 A or 2310 A. To calculate the new "robustified normal" value for each of these points, the system may calculate different values. For example, the system could take the mean or median value. The advantage would be the simplicity of the calculation. But it also would lose the matching to the local changes of the curves, so it could miss changes in load start times due to different seasons and usages. This is for example very true for the winter period where the heating often starts earlier to get the building to correct heat temperature before users enter the building. While during interseason, or during summer period, no or little preheating or precooling is required due to acceptable ambient temperatures in early morning as well as to the thermal inertia of the building. Another exemplary representation of the corrected load start time value if illustrated by the line 2302. This line is used to replace the daily values 2308 A by 2308 B, and 2310 A by 2310 B. This line 2302 has been calculated by first identifying a local upper and lower threshold of local normal value and variance illustrated by 2304 (upper local limit) and by 2306 (lower local limit). To calculate this one exemplary method would be to use all the points of 2202 and apply functions such as a roll mean or median on 7 days and to add or subtract to these the acceptable variance (standard deviation or interquartile range). Similar methods have already been described previously, so we will not restate details. Then, on the points selected between these local normal values, the system may calculate the mean or median value 2302.

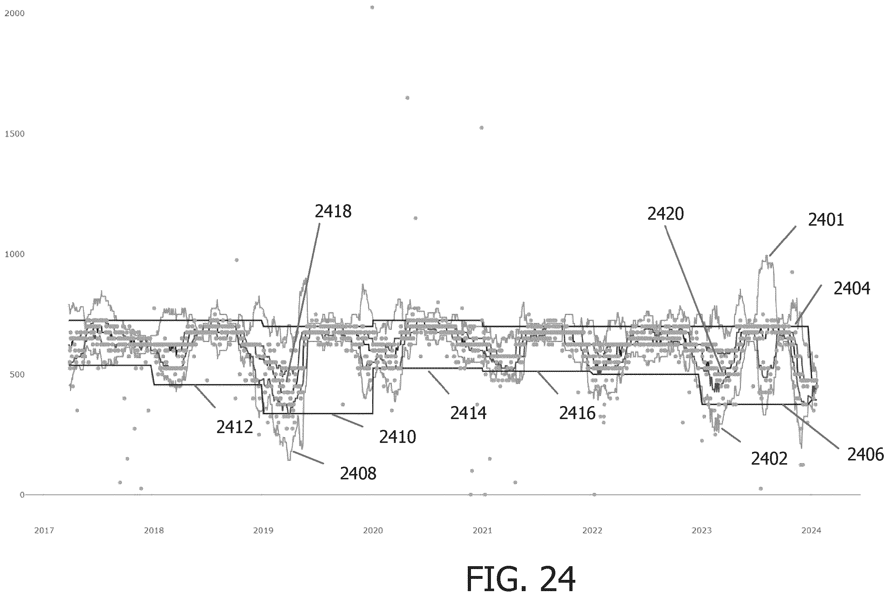

FIG. 24 provides an exemplary illustration of how to calculate the upper and lower yearly boundaries 2404 and 2406 (equivalent to 2204 and 2206). As exemplary implementation, the system may use the same method as described above (sliding roll mean or median to which is added and subtracted the variance), a model is calculated based on all available daily load start time data points. This creates the upper limit 2401 and lower limit 2402. Using this, the system may infer a yearly value such as a median or mean value for each yearly upper limit 2404 and lower yearly value 2406. These calculations may again be analyzed and provide valuable insight to the system and to the user (for example the facility manager). For example, it now becomes visually obvious that 2 of the years display a much earlier acceptable load start time: 2019 and 2023. This is due to normal data points 2418 and 2420 dropping much earlier time values than the previous and following year(s) for example. It is easily recognizable to the user by comparing the line's level of 2410 to 2412, 2414 and 2416 for example. (Very little data is yet available in 2024 at the time of this writing). It is noteworthy that for this specific site, the load start time upper limit does not vary a lot over the years. Again, it is important to keep in mind that each site, and each building has its own model, and that such a model changes over time (year(s), season(s), month(s), week(s)) due to many factors such as for example changes in settings of the HVAC or lighting, or due to changes in usage of the building (e.g., due to yearly schedule of class rooms in a university campus), just to name a few.

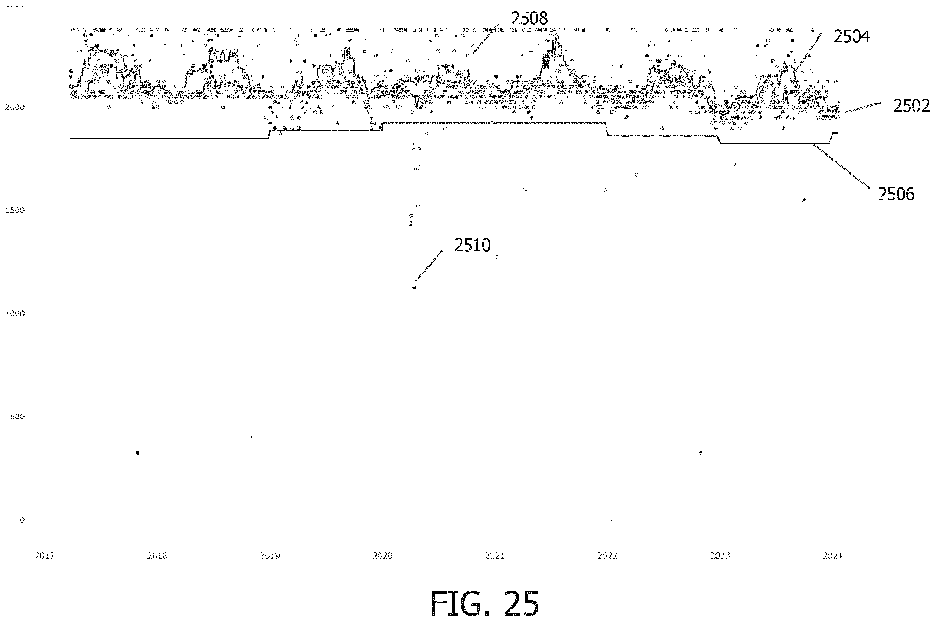

FIG. 25 shows a similar approach for the decrease end time. In this case there is a noteworthy difference as the upper limit 2504 is not a yearly model, but is a sliding window of a function of 75^{th} quantile (quartile 3) value. This allows for more local variations of this upper limit. This shows that the system may have different settings and methods may be applied when relevant to tune the system per type of analyzed model. It may even be possible to automate this tuning to best fit each site and building (e.g., what is the best model to represent the site, as well as the best performing savings analysis). It this exemplary illustration, many points are in the outlier zone 2508 and points above. Again some fewer outliers are detected and visible (example of 2510) below the yearly lower limit 2506.

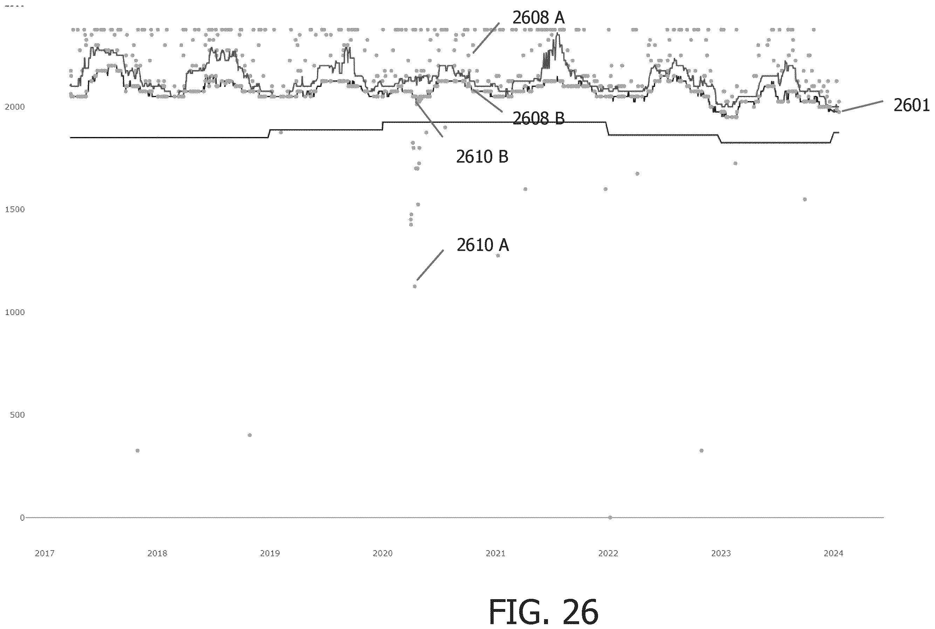

FIG. 26 shows a recalculation of the decrease end time for the outlier values, according to a similar method as described for the load start. Outlier points above and below have their recalculated values represented by the line 2601, so 2608 A gets the value of 2608 B, and 2610 A gets the value of 2610 B.

The process 1500 proceeds to 1516, as shown in FIG. 15A, to create temperature models by, for example, selecting usable references per year (or whatever is correct learning model period) and completing the models for the year (or whatever is validity of building signature model period) with data for days from the previous and/or following year (or other relevant application/validity period). In an embodiment, step 1516 also includes preparing the data (e.g., data loading and sanity checks, data binning and aggregation, and smoothing) and iterating with machine learning to optimize parameters (e.g., identify and remove outliers from modeling, identify number of segments "cut points"). In one example implementation, the parameters are optimized after manually training/teaching a machine learning system to identify outliers and cut points. For example, the specific equipment (or processes) operating at a given time allow the system to learn (i.e., a form of machine learning). In another example implementation, the outliers and cut points are detected by automatically identifying them using state of the art machine learning algorithms (e.g., using time series clustering, local regression lines, change points identifications or using spectral or any other algorithms helpful in analysis to identify patterns).

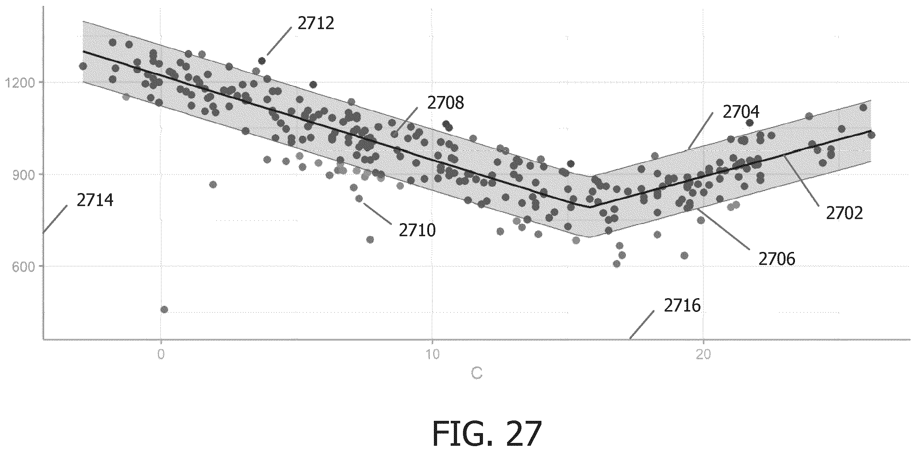

Referring further to step 1516, creating temperature models according to an embodiment includes: automatically creating a regression model (e.g., a building signature - core model); creating a robust multi segment linear regression model (as well as a loess curve with local regression for a more locally flexible model); automatically identifying and selecting the best possible building signature model by, for example, tunnel bandwidth around the regression line (e.g., a building signature - complete model), using statistical tests and expert rules; FIG. 27 is an exemplary illustration of such a model. This example is on a yearly model of open days, open hours. A regression line 2702 is used as a model of the expected energy consumption for a given temperature. The Y axis of the mean energy consumption in kWh is indicated at 2714 and the X axis of the daily mean temperature is indicated at 2716. Reference character 2704 illustrates the "normal" upper limit and reference character 2706 shows the "normal" lower limit. Any point within this "tunnel" is considered a "normal" energy consumption 2708. Any point above or below this "tunnel" is considered an outlier (e.g., 2710, 2712) and if it is an overconsumption (2712), then it may generate an alarm in a connected real time system or send an alarm per email or to display on a smartphone.

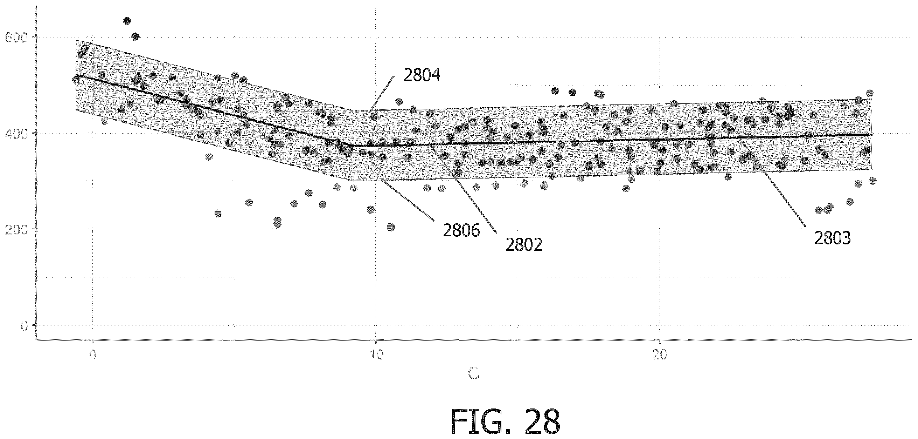

FIG. 28 is a similar exemplary illustration, with a similar logic, but focused on the closed hours / closed days. It is noteworthy when comparing the two figures to highlight the fact that the closed hours model of this FIG. 28 displays a relatively "flat/horizontal" line after the change point. This means that little cooling is turned "off" during closed hours (during nights and week end days) and so the energy consumption during hot days seems fairly small. This is visible in comparing the values of 2802 and 2803, where 2802 is in the "no heating-no cooling" zone and 2803 is in the "cooling" zone. In this example, lines 2804 and 2806 are equivalents for the lines 2704 and 2706 of FIG. 27.

Referring further to step 1516, creating temperature models according to an embodiment further includes: identifying the different components of the building signature (e.g., applying "model-based clustering, classification, and density estimation based on finite normal mixture modelling" algorithm), and creating a yearly view to show periods of each component; and iteratively applying this model build by drilling down on each signal of the building, such as daily average, open hours of open days average, closed hours of open days average, closed hours of closed days average, sum per day or type of hours, etc.

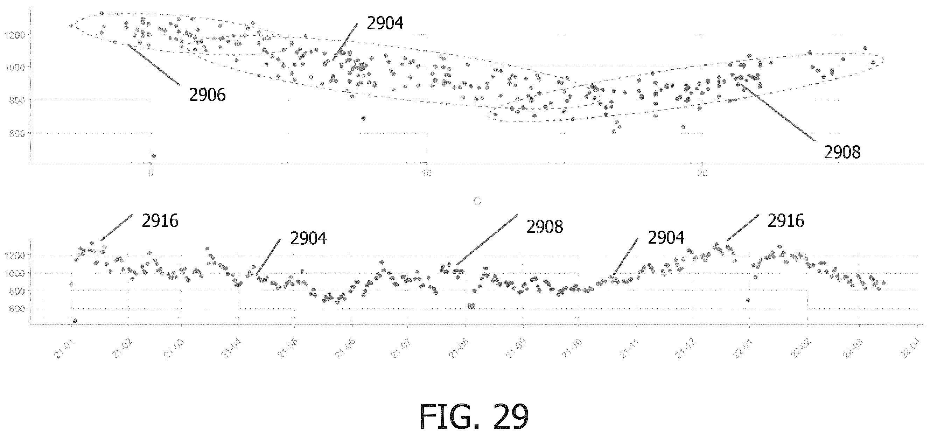

FIG. 29 is an exemplary illustration of the de-composition of the different components. This example shows a simple to understand component analysis where reference character 2906 indicates a "cold days" cluster and reference character 2904 indicates a "little heating" cluster, and reference character 2908 indicates a "no heating, progressive cooling" cluster. It is noteworthy to understand that often clusters may show different/more complex clusters, especially when settings on HVAC components have been changed during the year. In our exemplary illustration, the corresponding calendar periods are thus matching: Being in the northern hemisphere, cold winter days require strong heating December-March, and some days may be warmer than others, so there are interwoven colors in February and March. Less heating happens between March and April, and October and November. May and September are typically transition months, where some heating, some cooling or no heating no cooling may occur, and then June-August are warm months and often will require cooling.

In other implementations, any other relevant algorithm, method and technique may be leveraged to build relevant analysis models. The temperature is here in 1516 provided as one exemplary representation of many possible drivers. And the regression line could as well be a spline model, a loess function, any other curve fitting algorithm, just to name a few alternatives for illustration purposes.

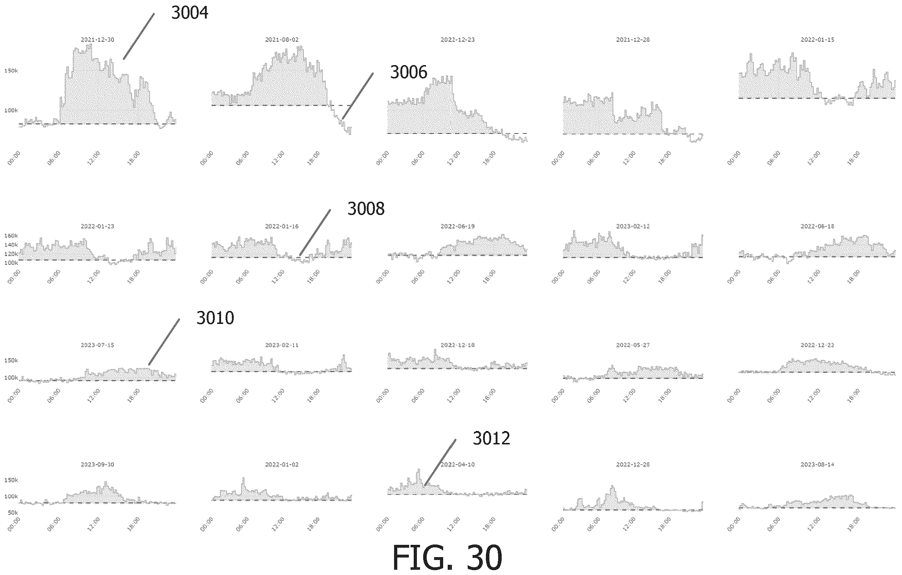

In an embodiment, the process 1500 further includes identifying potential savings on incoherences of a process running high during time periods of closed hours, as indicated at 1518. Identifying the potential savings includes, for example, identifying savings for closed days, identifying savings for holidays, and identifying savings during closed hours of open days (e.g., Monday-Friday nights). FIG. 30 is an exemplary illustration of the top 20 worst days of over-consumptions. The potential detected savings are high-lighted in the colored areas of each day. As stated earlier these days are mainly weekend days. They may display common patterns, or very different shapes and forms and thus different over-consumption patterns (savings). This is the case on this exemplary site, where the closed days have different shapes, so display different reoccurring patterns. For instance, reference character 3004 indicates a typical open shape day, which may be indicative of processes and loads incorrectly turned off. The visualization displays a strong drop at the end of the day at 3006, far below the local baseload level, and displays low values during the day at 3008, but with abnormally high values in the night before and after. Reference character 3010 illustrates, for example, a process incorrectly managed, starting mid of day, and continuing without being turned off the following night, and reference character 3012 illustrates, for example, a process with a strong loacl sokie in the early morning, then turning progressively off, at mid of day.

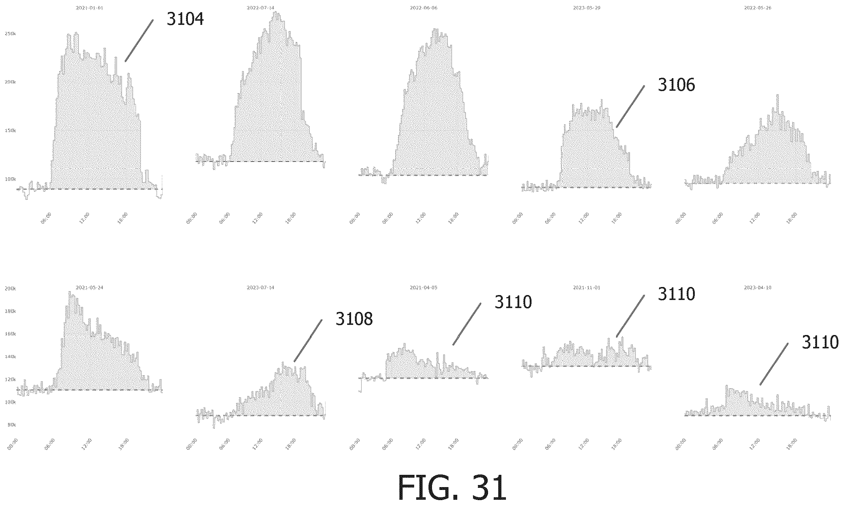

FIG. 31 is an exemplary illustration of the top 10 worst holidays, showing over-consumptions. The potentially detected savings are high-lighted in the colored areas of each day. These are only the holidays occurring on "normally open days" (so are not holidays which may occur on weekend days). Again the same comments on the variety of shapes. Reference character 3104 shows very high energy consumption, typical of an open day in winter period (heating). Reference character 3106 displays a typical "half day open level". It is noteworthy to say that many sites have holidays which have processes partially turned off, partially running like open days. This makes these days hard to classify and explains why the system uses multiple features in the step 1504. Reference character 3108 has most of its over consumption after 2pm, while 3110 shows a typical closed day variation profile. But as noted before, the shapes could also be more similar and repetitive, as this depends on the site's settings and control system(s).

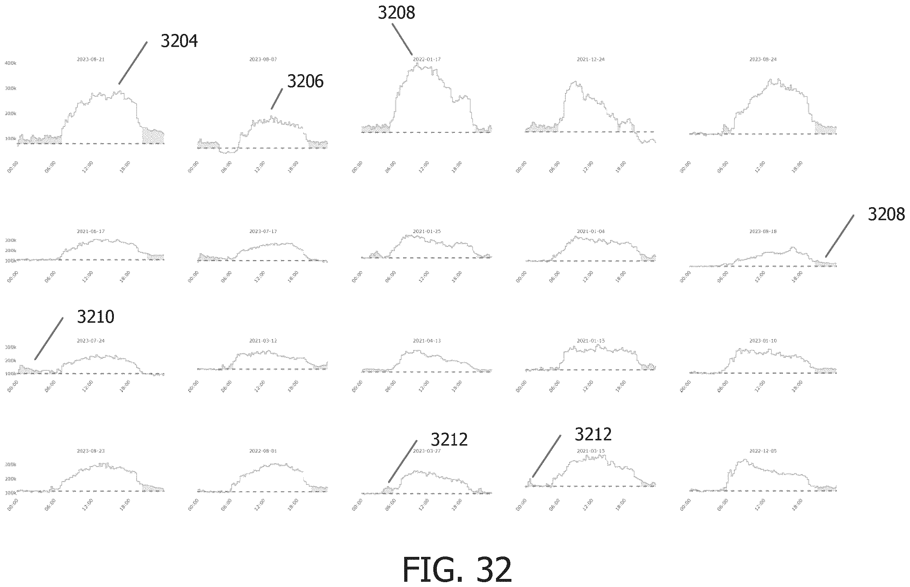

FIG. 32 is an exemplary illustration of the top 20 worst open days, showing over-consumptions. The potentially detected savings are high-lighted in the colored areas of each day. Again the shapes vary a lot and the system may classify the early morning over-consumptions (3210), the early night over-consumptions (3208), both constant high levels of baseload during the early morning (before the load start) as well as the early night (after decrease end) illustrated by 3204, as well as local spikes and limited peak periods in 3212. One specific day 3206 is noteworthy to observe. This day has a dip in the day between 4am and 7am. This dip is not confused with the baseload level, as this baseload level is calculated by taking into account the previous and following day(s). At 1520, the process 1500 also identifies potential savings on incoherences of levels of daily closed hours energy consumptions (vs. temperature) based on, for example, identifying incorrect levels of daily base load (and the corresponding potential savings) in addition to the process 1518 identifying savings for closed days, identifying savings for holidays, and identifying savings during closed hours of open days (e.g., Monday-Friday nights).

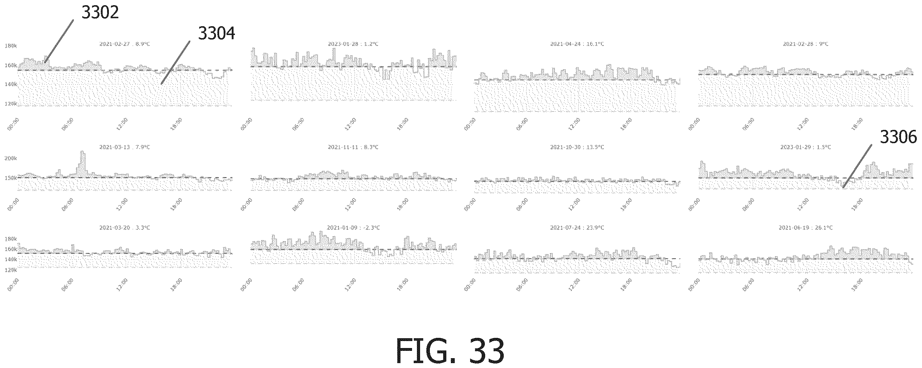

FIG. 33 shows the worst 12 days of inconsistent baseload levels. Reference character 3302 is an exemplary illustration of the incoherent closed hours over consumptions detected in 1518. Reference character 3304 is the inconsistent baseload level over consumption / savings (this is the worst day for this exemplary site). In this case the top 12 are mainly closed days and holidays. This may be expected, as the open days do not have as many closed hours, so a lower baseload level will have less surface during an open day vs. a closed day. Reference character 3306 is noteworthy to mention because in this particular case the min value of the day is close to the calculated regression level of the baseload.

Proceeding to 1522, the process 1500 normalizes each point and each period of each day by defining daily and yearly statistics and calculating the normalized value thus removing seasonal and temperature-related signals and variance. The normalization part is essential to compare the shapes of the days without taking into account other factors such as temperature, variance, etc. This allows clustering to detect only homogeneous groups in terms of shape which makes outliers more recognizable. To normalize, we may use the statistics of the day and the year such as the average, the median, the min and the max in order to remove the seasonality. Several cycles of clustering may be performed: With the closed hours as-is measured (today). Or the system may first apply the calculated savings to remove the signal of the closed hours from impacting the clustering. This generates a clustering more focused on the open hours with the transition period(s) points. Or the system may also replace the transition period points by the baseload level to get the clustering only of the open hours. This clustering will produce a clustering where only the shape of the open hours is discriminant. It should be obvious for anyone skilled in the art, that each clustering presents a useful layer to leverage in the analysis.

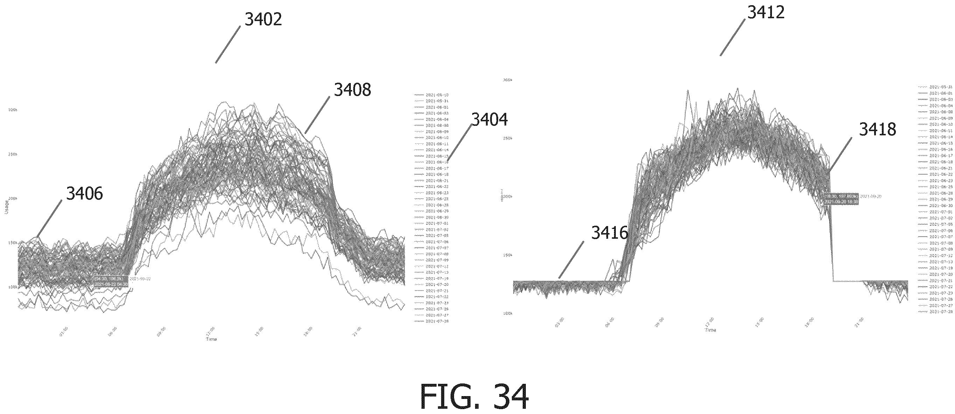

FIG. 34 is an exemplary illustration of one cluster. Reference character 3402 illustrates the overlaying of the energy measured values. Reference character 3404 shows some of the days of this cluster. Reference character 3406 shows the different levels of baseload and reference character 3408 shows the different levels of energy measurements during open hours. Next to this, 3412 illustrates the same cluster, with same days, after applying normalization and removing the over consumptions during the closed hours. Reference character 3416 shows how the variance of closed hours has been diminished, and reference character 3418 is the main signal used for this clustering of open hours. At 1524, the different daily grouping models (aka "clusters") and resulting daily shapes are identified (e.g., a first cycle is on closed hours models, then transition periods models, and then open hours models). Step 1524 includes, for example: identifying the number of different typical groups (e.g., using unsupervised machine learning); identifying the different shapes of each group; defining the discriminant characteristics of each group and checking against rules (e.g., clusters of days vs. seasons and within seasons vs. groups of temperature); and iterating and building progressively all models through the different types of hours (e.g., a first cycle with closed hours models, then with transition periods models, and then only with open hours signal models). For example, machine learning may be used to recognize the shapes of usage curves to identify areas for savings. One shape may be prevalent during the winter while another shape is prevalent during the summer. According to this example, a particular curve may have a relatively shallow ramp up during the winter resulting from heating a building; recognizing this shallow ramp may indicate that heating could begin later such that the early over consumption can be eliminated.

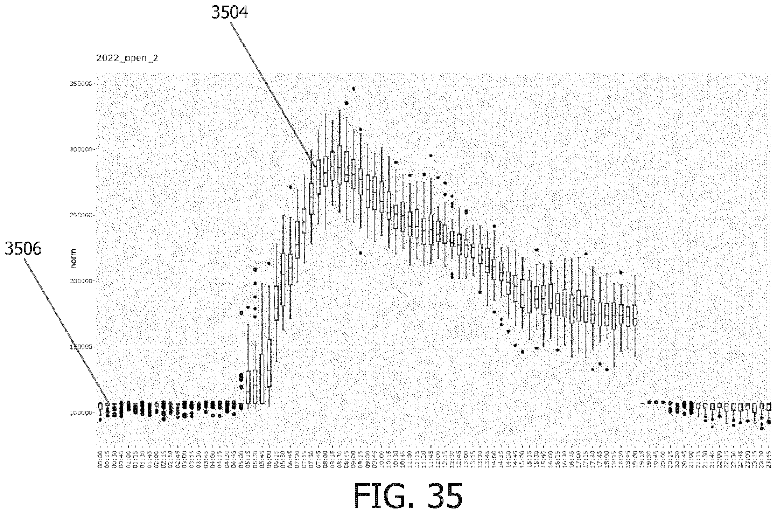

FIG. 35 is an exemplary illustration of some of the statistics which may be calculated for each cluster and each timestamp. This typically includes min, max, median, q1 and q3, etc. To illustrate these statistical values, in this graph the system uses the box plot (example of open hours 3504) which is well known to anyone skilled in the art of data science (the box is on its lower bound the 25^{th} percentile value, the "middle bar" value is the median, then the upper bound is the 75^{th} percentile, and the whiskers above and below represent the points within the normal variance, and points above, represent outliers outside normal variance). In 3506 values are generally in the baseload values, so the boxplot is often a single value, and only outlier points are visible in this example.

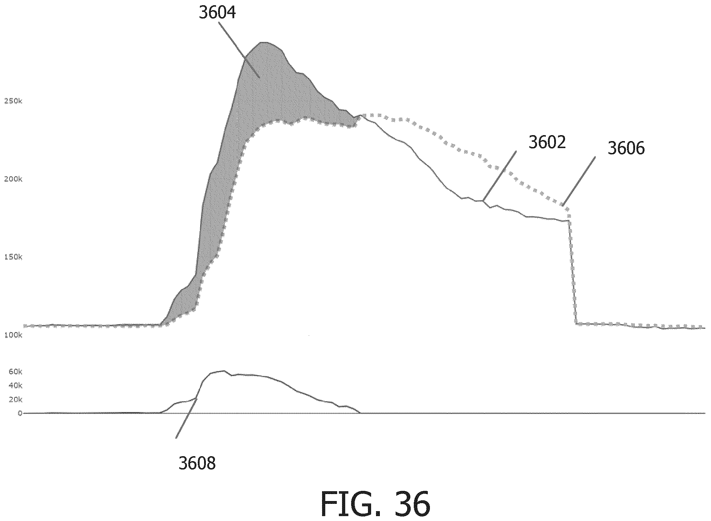

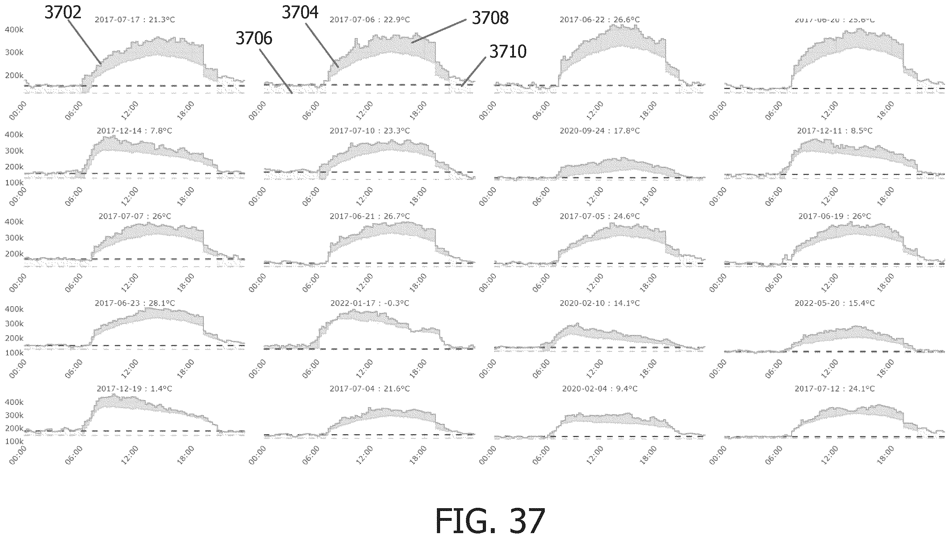

FIG. 36 is an exemplary illustration of this same cluster, when compared to the yearly model (for example based on the median value of all the normalized days for each timestamp). Reference character 3602 represents the cluster's shape (based on the previous statistical values chosen by the system as the best representation. Reference character 3606 represents the yearly all cluster all days normalized model. The system then calculates the differences represented here by Reference character 3604. From this it may be obvious for any energy manager skilled in the art, that this is a winter cluster, where more energy is consumed to heat the building in the morning, until the expected temperature of the building is reached and the outside air temperature as well as the sunlight, reduce the need for heating. In this illustration the major heating happens before 10am. FIG. 37 displays the worst 20 open days where different cluster shapes are visible. Reference character 3704 displays an example of a summer profile where most of the over consumption appears after 12am, with a sharp drop after 6pm (after the sun irradiance is not touching the building due to shade and angles).

Referring now to FIG. 15B, at 1526, process 1500 identifies potential savings on incoherent daily start times and end times of the different types of hours (e.g., a first cycle is on closed hours models, then transition periods models, and then open hours models). In an embodiment, step 1526 includes identifying typical and relevant start time models and end times models and identifying potential savings for each day when leveraging the applicable start times models and end times models.

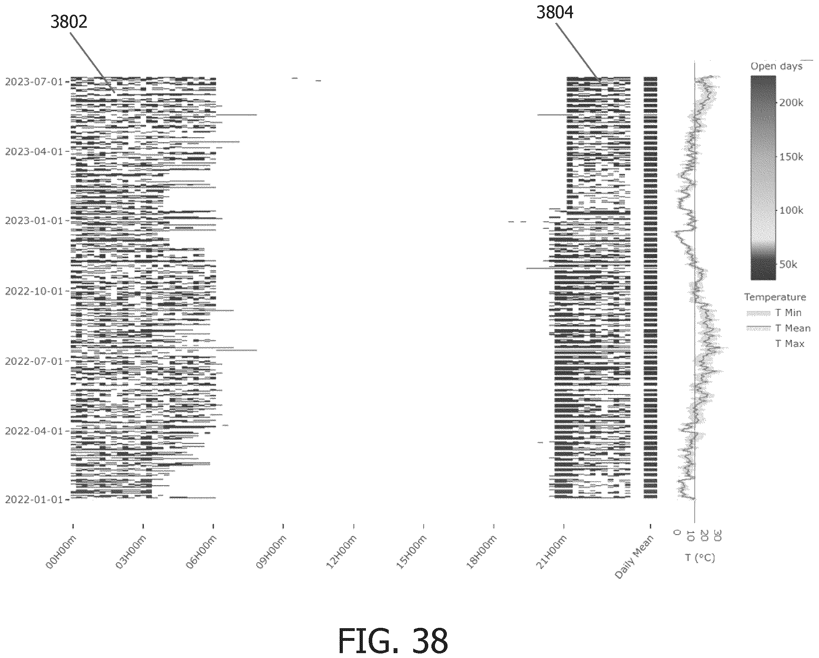

FIG. 38 is an exemplary illustration of the periods which would normally be in baseload, so before the load start, and after the decrease end. This type of graph is commonly used in energy management reports. It is called a "heatmap" and shows the consumption levels. In this example, the dark color is used to show the baseload period for the open days only (in this example the dark color shows identified savings during the closed hours, before load start and after decrease end). When analyzing the appearing load start time and the decrease end times of these dark color points, it shows that there are global yearly models to set the load start 3802 and the decrease end 3804, but also that there are variations due to the cluster related statistics of load start and decrease end change points. There are multiple ways to calculate these and to apply rules to tune the system to the building. For illustration purposes, it should be mentioned that expert user inputs may be leveraged to define priorities and time settings in the HVAC system. This may be then refined with the statistical models described in the previous sections. Inputs form the daily clustering. Inputs from the yearly models. Inputs from each day's robustified load start and decrease end. Just to name the ones explicitly described in this application. The system will then use a statistical or rules based resolution algorithm to define the load start time(s) and the decrease end time(s), leveraging combinatory rules ("calculate the mean, median" etc.) or a cumulative rule ("take the first" or "take the latest"), or more complex rules and weighted resolution algorithms (a topic of data science and expertise, which is beyond the scope of these illustrations).

At 1528, the inferred models of each point of each day are re-contextualized. This includes defining and leveraging daily and yearly statistics of models and calculating the rebuild energy value, so as to leverage seasonal and temperature related signal and variance. Different statistics may be applied to the different daily values such as on the open hours, on the transition periods and on the closed hours. More fine grained categories may be used as well as described in the signal extraction (CAT1 being values below the baseload for example). Each category may be set back into its daily statistical value as well as leveraging the different temperature predicted values (or any other relevant drivers such as windiness, rain, solar radiance, or more specific building related or usage related drivers such as number of visitors, number of plates served, etc. Just to name a few drivers of energy consumption).

The process 1500 proceeds to 1530 to identify potential savings on incoherences of levels of daily open hours energy consumptions (vs. temperature). In an embodiment, this includes identifying the savings using the shape and level analysis as well as identifying incoherences and abnormal over consumption features (spikes and peak periods). At 1532, the process 1500 identifies potential savings on incoherences of levels of daily transition periods energy consumptions (vs. temperature), including identifying the savings using the shape and level analysis, as well as features analysis. Proceeding to step 1534, the total potential savings per period are shown in the form of, for example, energy and/or cost savings, heatmaps, recommendations for corrective actions, and the like.

FIG. 37 is an exemplary illustration of the savings calculated and worst cumulated savings (closed hours and open hours and transition period savings). In this illustration, the top 20 worst days, 3702 shows the energy consumption measured today for each day. Reference character 3704 shows the calculated and recontextualized cluster (leveraging the temperature prediction calculated in the building signature model(s). Reference character 3706 shows the baseload level calculated for this day for the closed hours, again based on the building signature model(s). Reference character 3708 shows the savings on open hours and transition hours, and the reference character 3710 shows the savings in the closed hours. Each layer of savings may be calculated separately, or the savings may be calculated globally, or per timestamp, etc. The process 1500 ends at 1536.

In one implementation, each day, the system may display in a real time system (e.g., a mobile application, or a website application or page) the detected savings/over-consumptions. The over consumption may be calculated and/or displayed on any given time period (day, within the day, or any longer period of days, week(s), month(s), quarter(s), year(s)).

In another implementation, leveraging only a single meter installed in each of many different buildings may be very helpful to manage a portfolio of buildings. Being able to compare over consumption detected on many buildings, may for example be useful to rank buildings higher or lower for maintenance or revamping actions. In one example this may focus on buildings where the calculated baseload ratio is very low. This for instance may be indicative that many running loads may not be turned off adequately. And maintenance actions may be able to lower the consumption level overall. Being able to compare over consumption detected on many buildings, may for example be useful to rank buildings where the load start time or the decrease end time are not adequately set (e.g., when the office or university building has no more occupancy, but the heating or cooling lasts 2 hours longer than the occupancy). This type of analysis may also be very useful to determine the priority ranking of buildings to be equipped with more main and submeters. A portfolio manager would naturally prioritize sites for which over consumptions are detected and some recurring patterns are visible over sites for which he or she would need additional meters to identify the locations of main contributors to over consumptions. This illustrates a few applicable examples of when only the main meter is installed and analyzed but still provides significant value for a building portfolio manager.

In another exemplary implementation, the system may display the detected savings/over-consumptions in a generated html or pdf report, or in an edge software application.

In yet another exemplary implementation, a gateway or edge software system or an edge building management system, for example, may take an action to avoid a detected over-consumption to be repeated the next day or the next same day of week the following week. Such over consumption may be tracked in the system to a load on which maintenance was performed and settings changed. In this instance, an exemplary action taken by such a system/IED could be reverting the settings changes back to the settings that were implemented and operational on the previous day. Another example would be turning off a "forced on" operating mode for a rooftop unit which was required during maintenance operations, and then left "on" (which may have been forgotten after the end of day in maintenance mode).

FIG. 16 illustrates further aspects of the present disclosure providing advanced energy analytics. In the example of FIG. 16, an energy usage curve 1602 spanning a 24-hour period is shown. The curve 1602 represents the measured values from a "utility shadow meter" (e.g., a meter at the entry point of electricity for the building), or may be an aggregation of data collected from a plurality of meters, such as meters 118 described above and indicates over consumption at 1604 during closed hours of 9:00 pm to 12:00 pm. Each of the curves 1606 represent individual data collected by each meter 118 (these may be called the main meters). A typical building will have a small number of incomers from the power utility that are globally linked to the building or to specific major parts of the building. Each incomer will have one or more main meters and each main meter often has one or more sub-meters. The hierarchical structure of the meters (e.g., meters 118) permit highly granular identification of the likely contributor to an over consumption. For instance, analytics can begin with data of a main meter and then show/enable expanded operational value as new meters are added as mains and sub-meters. Examining the shutdown hours of each meter 118 can lead to more actionable recommendations for managing energy usage.

In FIG. 16, it can be observed that the usage curves 1606 measured by all but two of the meters 118 essentially are at their baseload levels during closed hours in the early morning hours (before 6am) as well as at the beginning of the night (after 8pm). Some of the curves 1606 rise during open hours and then drop to their baseload levels at the end of the work day. Others of the curves 1606 indicate relatively constant usage (within their normal variance) such that there is no significant change between the baseload period and the running period. The meters 118 that produce these curves 1606 can be classified as not main contributors to the over consumption. Two curves 1608 and 1610 remain elevated during the over consumption period 1604 (they do not drop back to their respective early morning baseload levels). Advantageously, the meters 118 that produce curves 1608, 1610 can be classified main contributors and, thus, an analysis of the equipment monitored by these meters yields important information for managing energy usage and reducing over consumption. These observations made in the above description may be automatically conducted as an analysis in the system. This may occur at the meter's level, or at any aggregation level above (gateway, edge software level or cloud for example). Each main meter and each sub meter may have its own model. Each model, as explained above, will potentially calculate its own baseload, transition and open hours period(s) and different levels. For certain types of applications, such as lighting, these may be limited to only few discrete values reflecting the limited possible operating levels (e.g., when 3 lighting zones are defined and 0, 1, 2 or 3 zones may be either "on" at the same time). For other types of loads, these may be continuous values, such as for HVAC systems for example. In any case, certain loads may stay "on" and will be "constant" loads (e.g., the light of the underground system in a building, such as the security lighting of the garage). Other meters will have their own baseload levels, and variances during baseload period(s), as well as their own transition period(s) and open hours period(s). Each meter may thus have its own model. Yet, in addition, in an EPMS (e.g., an edge software system), the calculated closed hours period(s), or the transition period(s) or the open hours period(s) derived at the site level (e.g., the physical meter of the building or the aggregated main meter of the building) may be made available for the analysis of all the main meters and the sub meters. In one implementation, all the savings and all the periods (closed hours, transition hours and open hours) are calculated on the site meter, and then the system only looks for the main contributors of the over consumptions detected at the main site meter. In another implementation, the savings are calculated from the "bottom up", at each discrete meter, and then summed to build the aggregated view. In a third possible implementation, the two approaches described are performed and the results are cross evaluated. In a fourth implementation, for each level, a virtual meter is calculated by aggregating all the meters from the lower level, and then the residual is calculated and used as a virtual meter (the meter of the "unmeasured loads"). This adds insight and may show that the over consumption stems from non-metered load(s). This virtual meter is then analyzed and modeled the same way as physical meters, providing the logged interval measurements.

In this manner, aspects of the present disclosure permit correlating certain of meters 118 to the closed hours levels on open days and identifying which of the meters 118 are associated with regular contributors of the over consumptions and which are not. Generally, the meters 118 classified as associated with regular contributors will yield the greatest savings, depending on an analysis of different time intervals, the time of year, year-to-year comparisons, seasonal changes, outside temperatures, etc. It is to be understood that a similar analysis may be used to classify which meters 118 are associated with regular contributors of the over consumptions on closed days. In addition, significant improvements are possible using only the data from the main meters. In addition to a main meter analysis, one or more embodiments also identify what unmetered loads are contributing to over-consumptions. This residual analysis is possible by subtracting usage associated with sub-meters from the usage measured at the main meter. One or more embodiments further permits disaggregating seasonal usage from the over consumptions.

Aspects of the present disclosure further permit analysis of non-regular consumption, such as spikes and peaks occurring at different timestamps when (see FIGS. 12A and 12B) or closed days (see FIG. 13). For example, each of the individual energy usage curves from one day to the next can be compared by normalizing their shapes. As described above, one shape may be prevalent during the winter while another shape is prevalent during the summer. For this reason, it may be difficult to distinguish differences in the curves one day to another because they tend to have a global shape. Normalizing the curves removes the signals at baseload making the variances much smaller, which in turn makes outliers more recognizable.

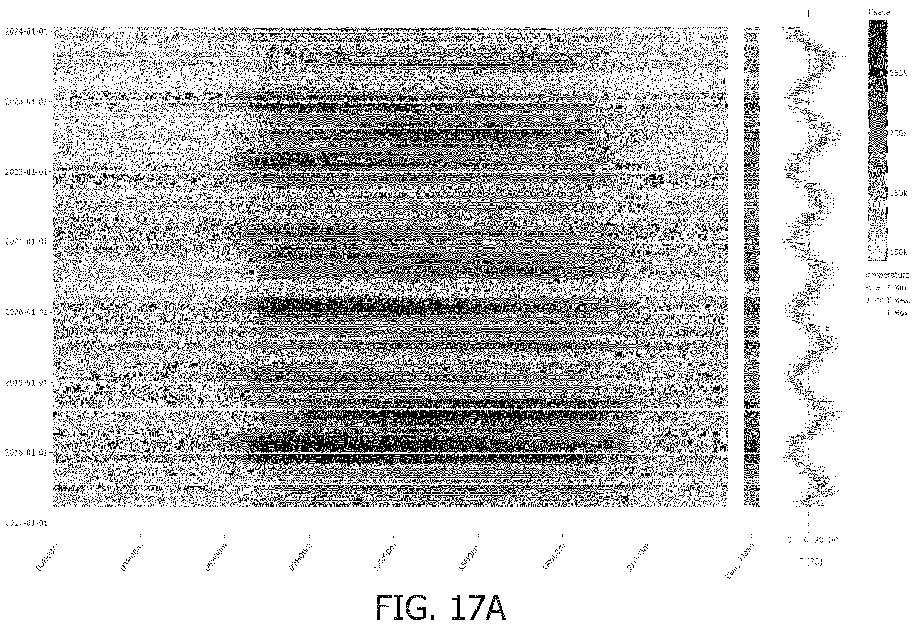

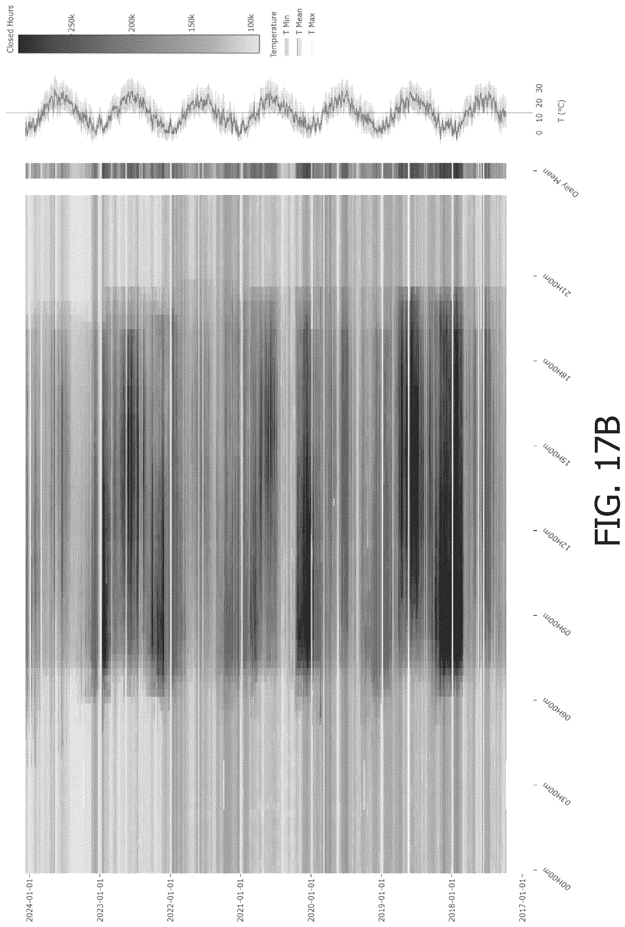

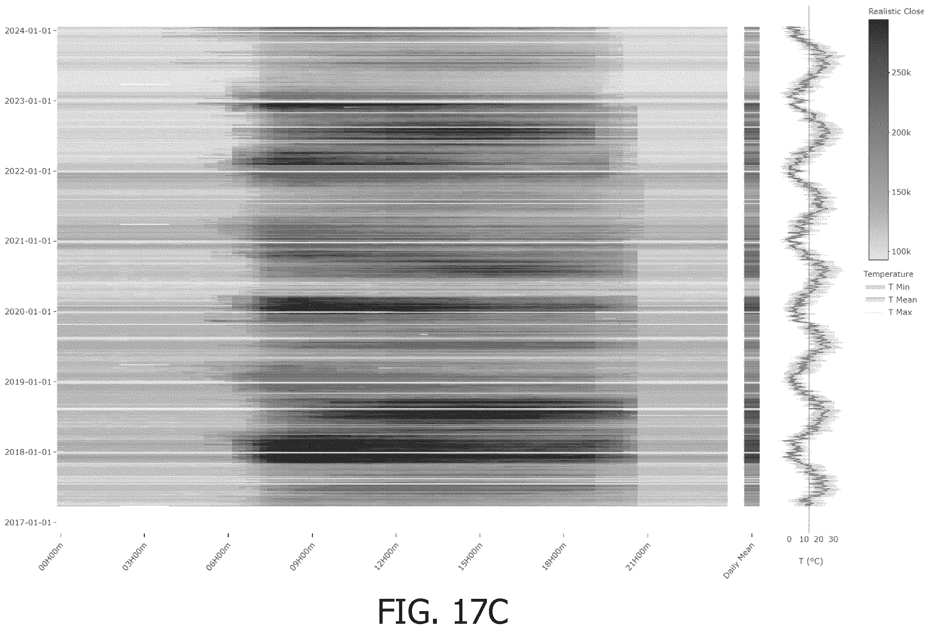

FIGS. 17A to 17C illustrate examples of heat map visualizations for demonstrating the impact of over consumption. In FIG. 17A, real energy consumption is shown for a three-year period on the y-axis. The x-axis begins at midnight and covers a 24-hour period. When viewed in color, each horizontal line ranges in color from green to yellow to orange to red, where green represents the lowest usage and red represents the highest usage. In FIG. 17A, for example, the heat map demonstrates lower usage during the regularly closed hours and higher usage during the regularly open hours. Periodic low usage days occur on the weekends. Over consumption occurring during the early morning and night hours indicated at the bottom left and bottom right corners of the heat map improved over the course of three years, at indicated at the top left and top right corners of the heat map. FIG. 17B modifies the heat map of FIG. 17A to more clearly delineate the boundaries between open hours and closed hours. FIG. 17C modifies the heat map of FIG. 17B to represent the areas for potential savings based on a clear boundary between open hours and closed hours at the end of the work day.

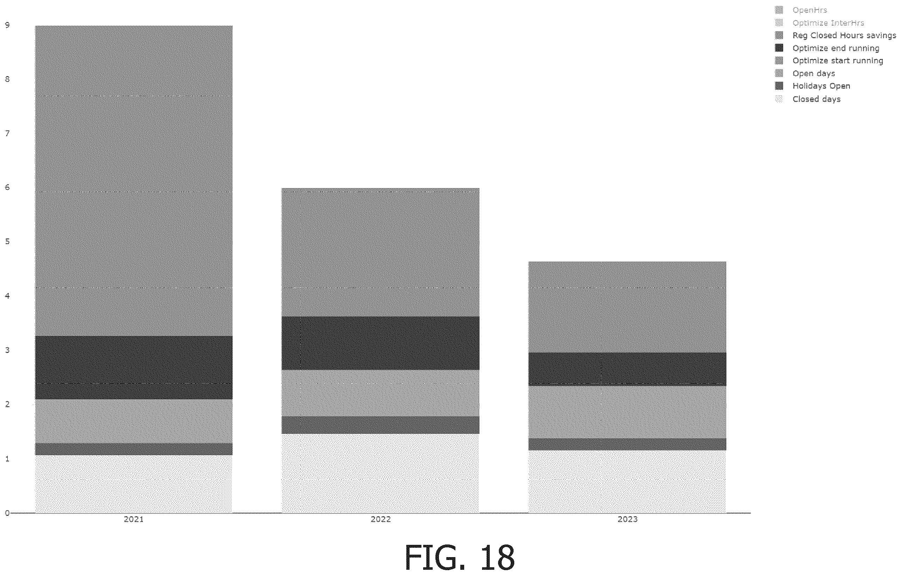

FIG. 18 is a visualization of a year-by-year comparison of savings of a well-managed site looking at open days, closed days, closed hours of open days, start/stop times, etc. The visualization illustrates savings during closed hours resulting from optimizing the end of the running period relative to energy usage during closed days, holidays, open days, etc. In the analysis, it is important to distinguish closed days and holidays. Buildings contribute 40% of global emissions, and some waste up to 30% of their energy. Smart building technologies minimize energy demand while keeping buildings comfortable, healthy, and productive for occupants. With seamless brand agnostic digital solutions and building analytics integrated into an energy management or building management system, operations can be optimized by, for example: identifying HVAC systems running off-occupancy hours due to scheduling errors and, thus, draining energy; quickly accessing the hot/cold complaints through trending indoor air quality data over a period or specific time; ensuring continuous air flow to match ASHRAE guidelines on temperature and humidity to foster higher confidence on return to work; and optimizing zone performance through automation of checks while minimizing disruption to tenants.

A method embodying aspects of the present disclosure provides signal extraction and alarming to enable advanced energy analytics. In an embodiment, the method comprises collecting energy consumption data for a site using one or more energy consumption meters and analyzing the energy consumption data to identify data clusters (i.e., data groups), the data clusters indicating a status of energy consumption at the site. The method also includes categorizing data of each of the data clusters based on one of more of a plurality of criteria. For instance, the categorizations indicate one of more of a plurality of energy consumption classifications. The method further includes analyzing the data clusters in view of the categorizations, information learned about the site (e.g., weather, occupancy and event information), and historical data to determine at least one of baseload for the site, baseload outliers, transition periods, stable periods in the transition periods, stable periods close the baseload, stable periods close to running hours, and running hours. In addition, the method comprises providing information for at least each day and each timestamp relating to the at least one of the baseload for the site, the baseload outliers, the transition periods, the stable periods in the transition periods, the stable periods close to the baseload, the stable periods close to running hours, and running hours in at least one visualization, as well as taking at least one action based on this information by identifying over consumptions and then triggering the at least one action.

In an embodiment, additional site information is collected. The additional site information includes at least one of weather data, an operating schedule, an event schedule, occupancy, solar irradiance, number of dishes served, attendance, number of visitors, or historical energy consumption data. Also, the model of normal energy consumption is a function of the additional site information.

Another method embodying aspects of the present disclosure provides advanced energy analytics. In an embodiment, the method comprises collecting energy consumption data for the site using one or more energy consumption meters, analyzing the energy consumption data to identify data clusters that indicate a status of energy consumption at the site, and categorizing the data clusters based on one of more of a plurality of criteria. For instance, the categorizations indicate one of more of a plurality of energy consumption classifications. The method further includes analyzing the data clusters in view of the categorizations, information learned about the site (e.g., weather, occupancy and event information), and historical data to identify over consumption periods and associated over consumption patterns for the site and analyzing the over consumption periods and associated over consumption patterns to at least one of: identify main sources of over consumptions and co-occurrences between meters/sources, develop actionable recommendations for addressing the over consumptions and identify potential opportunities for savings, and determine a confidence level for each of the identified potential opportunities for savings. In addition, the method comprises providing at least one visualization or report based on or in response to the analyzed over consumption periods and associated over consumption patterns.

In an embodiment, at least one visualization includes one or more recommendations for improving energy consumption efficiency for the site and the recommendations include a confidence level that the recommendations will reduce energy consumption at the site.

Aspects of the present disclosure also include providing information for at least each day and each timestamp relating to the categorizing in at least one visualization. The at least one visualization displays information regarding energy consumption data.

In some embodiments, the methods and systems of the present disclosure can collect data from a data source other than an energy meter, such as a data file from a computer readable memory component.

In some embodiments, the system can trigger alerts at the main site or meter level. Submeters, which are connected to a single meter can also be used, and each submeter can trigger alerts.

The description of the above methods and systems in relation to "energy" consumption are also intended to cover methods and systems in relation to "power" consumption. Similarly, the description of the above methods and systems in relation to "power" consumption are also intended to cover methods and systems in relation to "energy" consumption.

It is to be understood that an input is data that a processor and/or IED receives, and an output is data that a processor and/or IED sends. Inputs and outputs may either be digital or analog. The digital and analog signals may be both discrete variables (e.g., two states such as high/low, one/zero, on/off, etc. If digital, this may be a value. If analog, the presence of a voltage/current may be considered by the system/IED as an equivalent signal) or continuous variables (e.g., continuously variable such as spatial position, temperature, pressure voltage, etc.). They may be digital signals (e.g., measurements in an IED coming from a sensor producing digital information/values) and/or analog signals (e.g., measurements in an IED coming from a sensor producing analog information/values). These digital and/or analog signals may include any processing step within the IED (e.g., derive an active power (kW), power factor, a magnitude, a relative phase angle, among all the derived calculations).

The above-discussed method (and/or other systems and/or methods discussed herein) may include one or more of the following features either individually or in combination with other features in some embodiments. For example, in some embodiments the energy-related signals captured by the at least one IED may include at least one of: a voltage signal, a current signal, an input/output (I/O) data, and a derived energy-related value.

In some embodiments, the above-discussed method (and/or other system(s) and/or method(s) discussed herein) may be implemented on the at least one IED called for in the above-discussed method (and/or other systems and/or methods discussed herein). Additionally, in some embodiments the above-discussed method (and/or other systems and/or methods discussed herein) may be implemented partially or fully remote from the at least one IED, for example, in a gateway, a cloud-based system, on-site software, an on-site remote server, etc. (which may alternatively be referred to as a "head-end" or "edge" system herein). In some embodiments, the at least one IED may be coupled to measure energy-related signals, receive electrical measurement data from or derived from the energy-related signals at an input, and configured to generate at least one or more outputs. The outputs may be used to identify the at least one potential load type associated with the characterized and/or quantified at least one identified variation/change in the electrical system. Examples of the at least one IED may include a smart utility meter, a power quality meter, and/or another measurement device (or devices). The at least one IED may include breakers, relays, power quality correction devices, uninterruptible power supplies (UPSs), filters, and/or variable speed drives (VSDs), for example. Additionally, the at least one IED may include at least one virtual (e.g., residual energy-related signal measurement) meter in some embodiments.

It is understood that the terms "processor" and "controller" are sometimes used interchangeably herein. For example, a processor may be used to describe a controller. Additionally, a controller may be used to describe a processor.

Embodiments of the present disclosure may comprise a special purpose computer including a variety of computer hardware, as described in greater detail herein.

For purposes of illustration, programs and other executable program components may be shown as discrete blocks. It is recognized, however, that such programs and components reside at various times in different storage components of a computing device, and are executed by a data processor(s) of the device.

Although described in connection with an example computing system environment, embodiments of the aspects of the invention are operational with other special purpose computing system environments or configurations. The computing system environment is not intended to suggest any limitation as to the scope of use or functionality of any aspect of the invention. Moreover, the computing system environment should not be interpreted as having any dependency or requirement relating to any one or combination of components illustrated in the example operating environment. Examples of computing systems, environments, and/or configurations that may be suitable for use with aspects of the invention include, but are not limited to, personal computers, industrial computers, server computers, hand-held or laptop devices, multiprocessor systems, microprocessor-based systems, set top boxes, programmable consumer electronics, mobile telephones, network PCs, minicomputers, mainframe computers, distributed computing environments that include any of the above systems or devices, and the like.

Embodiments of the aspects of the present disclosure may be described in the general context of data and/or processor-executable instructions, such as program modules, stored one or more tangible, non-transitory storage media and executed by one or more processors or other devices. Generally, program modules include, but are not limited to, routines, programs, objects, components, and data structures that perform particular tasks or implement particular abstract data types. Aspects of the present disclosure may also be practiced in distributed computing environments where tasks are performed by remote processing devices that are linked through a communications network. In a distributed computing environment, program modules may be located in both local and remote storage media including memory storage devices.

In operation, processors, computers and/or servers may execute the processor-executable instructions (e.g., software, firmware, and/or hardware) such as those illustrated herein to implement aspects of the invention.

Embodiments may be implemented with processor-executable instructions. The processor-executable instructions may be organized into one or more processor-executable components or modules on a tangible processor readable storage medium. Also, embodiments may be implemented with any number and organization of such components or modules. For example, aspects of the present disclosure are not limited to the specific processor-executable instructions or the specific components or modules illustrated in the figures and described herein. Other embodiments may include different processor-executable instructions or components having more or less functionality than illustrated and described herein.

The order of execution or performance of the operations in accordance with aspects of the present disclosure illustrated and described herein is not essential, unless otherwise specified. That is, the operations may be performed in any order, unless otherwise specified, and embodiments may include additional or fewer operations than those disclosed herein. For example, it is contemplated that executing or performing a particular operation before, contemporaneously with, or after another operation is within the scope of the invention.

When introducing elements of the invention or embodiments thereof, the articles "a," "an," "the," and "said" are intended to mean that there are one or more of the elements. The terms "comprising," "including," and "having" are intended to be inclusive and mean that there may be additional elements other than the listed elements.

Not all of the depicted components illustrated or described may be required. In addition, some implementations and embodiments may include additional components. Variations in the arrangement and type of the components may be made without departing from the spirit or scope of the claims as set forth herein. Additional, different or fewer components may be provided and components may be combined. Alternatively, or in addition, a component may be implemented by several components.

The above description illustrates embodiments by way of example and not by way of limitation. This description enables one skilled in the art to make and use aspects of the invention, and describes several embodiments, adaptations, variations, alternatives and uses of the aspects of the invention, including what is presently believed to be the best mode of carrying out the aspects of the invention. Additionally, it is to be understood that the aspects of the invention are not limited in its application to the details of construction and the arrangement of components set forth in the following description or illustrated in the drawings. The aspects of the invention are capable of other embodiments and of being practiced or carried out in various ways. Also, it will be understood that the phraseology and terminology used herein is for the purpose of description and should not be regarded as limiting.

It will be apparent that modifications and variations are possible without departing from the scope of the invention defined in the appended claims. As various changes could be made in the above constructions and methods without departing from the scope of the invention, it is intended that all matter contained in the above description and shown in the accompanying drawings shall be interpreted as illustrative and not in a limiting sense.

In view of the above, it will be seen that several advantages of the aspects of the invention are achieved and other advantageous results attained.

Accordingly, the present invention may also be described as follows, optionally in combination with one or more of the above-mentioned features of the present invention: Signal extraction enables advanced energy analytics. Energy consumption data collected for a site by energy consumption meters is disaggregated into a plurality of granular classifications by identifying baseload candidates among the data, grouping sequences of the baseload candidates based on timestamps, and categorizing the grouped sequences as either baseload points or non-baseload points, including transition and open hours classifications. A per meter model of normal energy consumption from the energy consumption data is generated as a function of the baseload points and timestamps and the data is analyzed to identify incoherences relative to the model.

## Claims

1. Method for providing signal extraction and alarming to enable advanced energy analytics, comprising:
collecting energy consumption data for a site using one or more energy consumption meters, the energy consumption data comprising a plurality of data points each having a timestamp and a value representative of a level of energy usage;
disaggregating the data points into a plurality of granular classifications, wherein disaggregating the data points includes:
identifying baseload candidates among the data points as a function of the data point values relative to an upper threshold and a lower threshold;
grouping sequences of the baseload candidates based on the data point timestamps; and
categorizing the data points of the grouped sequences of baseload candidates as either baseload points or non-baseload points;
generating a per meter model of normal energy consumption from the energy consumption data as a function of the baseload points and the data point timestamps;
analyzing the energy consumption data to identify one or more incoherences therein relative to the model; and
performing at least one action responsive to the identified incoherences and then triggering the at least one action.

2. Method as set forth in claim 1, wherein the at least one action includes at least one of: alarming, generating and a sending report, sending data to an external control system, sending data to an external analysis system, sending data to an external management system, triggering a control change in at least one device or system, or triggering a setting change in at least one device or system.

3. Method as set forth in claim 1 or claim 2, wherein generating the model of normal energy consumption comprises automatically identifying and characterizing different potential energy savings for a time period.

4. Method as set forth in any of claims 1 to 3, wherein disaggregating the data points into the plurality of granular classifications further includes:
identifying transition candidates among the data points as a function of the data point values relative to an upper threshold and a lower threshold;
grouping sequences of the transition candidates based on the data point timestamps; and
categorizing the data points of the grouped sequences of transition candidates as either transition points or non-transition points; and optionally
wherein disaggregating the data points into the plurality of granular classifications further includes categorizing the data points into one or more of a baseload period, a running period, a transition period, a stable period within a transition period, and an outlier as a function of the data point values or data value timestamps, and wherein the model of normal energy consumption is a function of the categorizing.

5. Method as set forth in claim 4, wherein categorizing the data points of the grouped sequences of transition candidates as either transition points or non-transition points comprises identifying a crossing count of the number of times the data points within the grouped sequences of transition candidates cross a virtual point.

6. Method as set forth in claim 4 or claim 5, further comprising providing information for at least each day and each timestamp relating to the categorizing in at least one visualization, the at least one visualization displaying information regarding energy consumption data.

7. Method as set forth in any one of claims 1 to 6, wherein generating the model of normal energy consumption comprises executing a machine learning algorithm for automatically learning to disaggregate the data points into the plurality of granular classifications.

8. Method as set forth in any one of claims 1 to 7, wherein the energy consumption data is:
analyzed on at least one of the energy consumption meters, a gateway associated with one or more of the energy consumption meters, edge software, or a cloud-based energy management system; and/or
periodically or continuously collected by the energy consumption meters.

9. System for energy management comprising:
one or more energy consumption meters configured to collect energy consumption data for a site, the energy consumption data comprising a plurality of data points each having a timestamp and a value representative of a level of energy usage; and
a controller in communication with the one or more energy consumption meters, the controller having a processor and a memory component, the memory component storing processor-executable instructions that, when executed, configure the processor to:
identify baseload candidates among the data points as a function of the data point values relative to an upper threshold and a lower threshold;
group sequences of the baseload candidates based on the data point timestamps;
categorize the data points of the grouped sequences of baseload candidates as either baseload points or non-baseload points;
generate a per meter model of normal energy consumption from the energy consumption data as a function of the baseload points and the data point timestamps;
analyze the energy consumption data to identify one or more incoherences therein relative to the model; and
perform at least one action responsive to the identified incoherences and then trigger the at least one action.

10. System as set forth in claim 9, wherein the at least one action includes at least one of: alarming, generating and a sending report, sending data to an external control system, sending data to an external analysis system, sending data to an external management system, triggering a control change in at least one device or system, and triggering a setting change in at least one device or system.

11. System as set forth in claim 9 or claim 10, wherein the processor-executable instructions that configure the processor to generate the model of normal energy consumption include processor-executable instructions that, when executed, further configure the processor to automatically identify and characterize different potential energy savings for a time period.

12. System as set forth in any one of claims 9 to 11, wherein the memory component stores processor-executable instructions that, when executed, further configure the processor to:
identify transition candidates among the data points as a function of the data point values relative to an upper threshold and a lower threshold;
group sequences of the transition candidates based on the data point timestamps; and
categorize the data points of the grouped sequences of transition candidates as either transition points or non-transition points; and optionally
wherein the processor-executable instructions that configure the processor to:
categorize the data points of the grouped sequences of transition candidates as either transition points or non-transition points include processor-executable instructions that,
when executed, further configure the processor to identify a crossing count of the number of times the data points within the grouped sequences of transition candidates cross a virtual point.

13. System as set forth in claim 12, wherein the memory component stores processor-executable instructions that, when executed, further configure the processor to categorize the data points into one or more of a baseload period, a running period, a transition period, a stable period within a transition period, and/or an outlier as a function of the data point values and data value timestamps, and wherein the model of normal energy consumption is a function of the categorizing.

14. System as set forth in any one of claims 9 to 13, wherein the processor-executable instructions that configure the processor to generate the model of normal energy consumption include processor-executable instructions that, when executed, further configure the processor to execute a machine learning algorithm for automatically learning to disaggregate the data points into a plurality of granular classifications.

15. System as set forth in any one of claims 9 to 14, wherein the energy consumption data is analyzed on at least one of the energy consumption meters, a gateway associated with one or more of the energy consumption meters, or a cloud-based energy management system.
